(19) Europäisches Patentamt
European Patent Office
Office européen des brevets

(11) EP 0 358 515 B1

(12) **EUROPEAN PATENT SPECIFICATION**

(45) Date of publication and mention
of the grant of the patent:
**04.06.1997 Bulletin 1997/23**

(51) Int Cl.⁶: **G03F 9/00**

(21) Application number: **89309098.5**

(22) Date of filing: **07.09.1989**

(54) **Device for detecting positional relationship between two objects**

Vorrichtung zur Positionsdetektion zwischen zwei Objekten

Dispositif de détection de position entre deux objets

(84) Designated Contracting States:
**DE FR GB NL**

(30) Priority: **09.09.1988 JP 225802/88**
**09.09.1988 JP 226010/88**
**14.08.1989 JP 209929/88**

(43) Date of publication of application:
**14.03.1990 Bulletin 1990/11**

(73) Proprietor: **CANON KABUSHIKI KAISHA**
**Tokyo 146 (JP)**

(72) Inventors:
• **Matsugu, Masakazu**
**Atsugi-shi Kanagawa-ken (JP)**
• **Yoshii, Minoru**
**Tokyo (JP)**

• **Abe, Naoto**
**Isehara-shi Kanagawa-ken (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
**US-A- 4 265 542          US-A- 4 694 186**
**US-A- 4 728 193**

• **PATENT ABSTRACTS OF JAPAN vol. 11, no. 138
(E-503)(2585) 02 May 1987, & JP-A-61 278136
(HITACHI LTD) 09 December 1986,**

**Description**

FIELD OF THE INVENTION AND RELATED ART

This invention relates generally to an alignment system for correctly positioning an object. More particularly, the invention is concerned with position detecting method and apparatus suitably usable, for example, in a semiconductor microcircuit device manufacturing exposure apparatus for lithographically transferring a fine electronic circuit pattern formed on the surface of a first object (original) such as a mask or reticle (hereinafter simply "mask") onto the surface of a second object (workpiece) such as a wafer, for relatively positioning or aligning the mask and the wafer, particularly three-dimensionally.

In exposure apparatuses for use in the manufacture of semiconductor devices, the relative alignment of a mask and a wafer is one important factor in respect to ensuring improved performance. Particularly, as for alignment systems employed in recent exposure apparatuses, submicron alignment accuracies or more strict accuracies are required in consideration of the demand for higher degree of integration of semiconductor devices.

In many types of alignment systems, features called "alignment patterns" are provided on a mask and a wafer and, by utilizing positional information obtainable from these patterns, the mask and wafer are aligned. As for the manner of executing the alignment, as an example there is a method wherein the amount of relative deviation of these alignment patterns is detected on the basis of image processing. Another method is proposed in U.S. Patent Nos. 4,037,969 and 4,514,858 and Japanese Laid-Open Patent Application, Laid-Open No. Sho 56-157033 (GB-A-2 073 950), wherein so-called zone plates are used as alignment patterns upon which light is projected and wherein the positions of light spots formed on a predetermined plane by lights from the illuminated zone plates are detected.

Generally, an alignment method utilizing a zone plate is relatively insensitive to any defect of an alignment pattern and therefore assures relatively high alignment accuracies, as compared with an alignment method simply using a traditional alignment pattern.

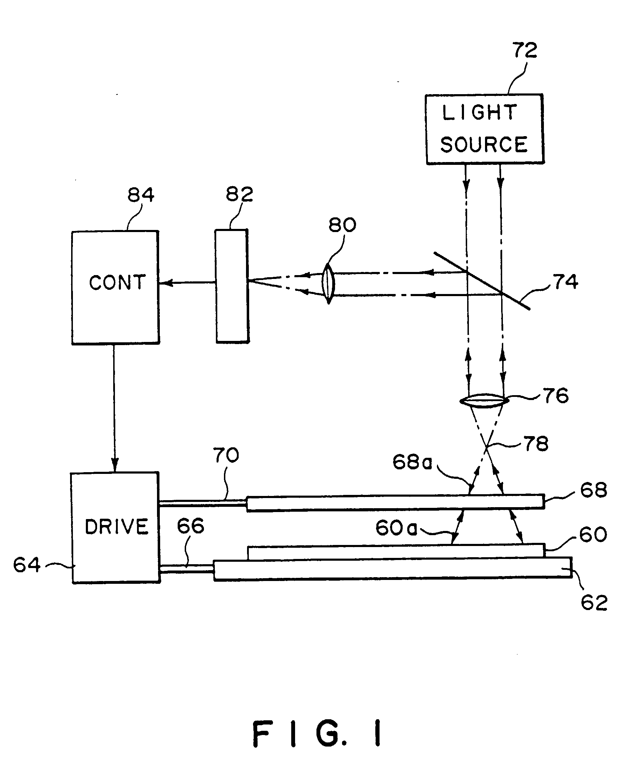

Figure 1 is a schematic view of a known type alignment system utilizing zone plates.

In Figure 1, a parallel light emanating from a light source 72 passes through a half mirror 74 and is focused at a point 78 by a condensing lens 76. Thereafter, the light illuminates a mask alignment pattern 68a on a mask 68 and an alignment pattern 60a on a wafer 60 which is placed on a support table 62. Each of these alignment patterns 68a and 60a is provided by a reflection type zone plate and functions to form a spot of focused light on a plane perpendicular to an optical axis which contains the point 78. The amount of relative deviation of the positions of these light spots formed on that plane is detected, by directing the focused beams to a detection plane 82 by means of the condensing lens 76 and another lens 80.

In accordance with an output signal from the detector 82, a control circuit 84 actuates a driving circuit 64 to relatively align the mask 68 and the wafer 60.

The zone plates 68a and 60a of the mask 68 and the wafer 60 have different focal lengths, which are different by an amount corresponding to a predetermined spacing between the mask 68 and the wafer 60. Usually, the zone plate 60a of the wafer 60 has a larger focal length.

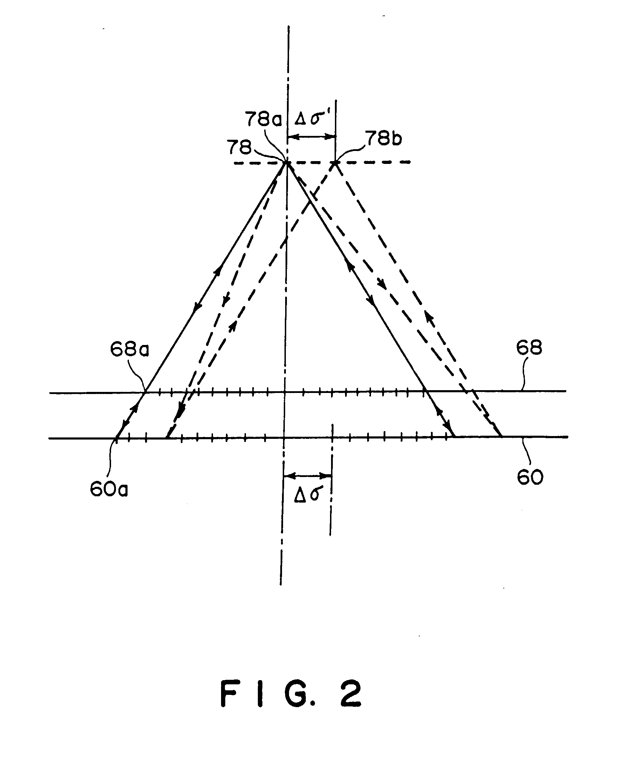

Figure 2 illustrates an imaging relationship of lights from the mask alignment pattern 68a and the wafer alignment pattern 60a shown in Figure 1.

In Figure 2, a portion of the light divergently advancing from the point 78 is reflectively diffracted by the mask alignment pattern 68a and forms a spot 78a of focused light at or adjacent to the point 78, the spot representing the mask position. Another portion of the light passes through the mask 68 in the form of a zero-th order transmission light and is projected upon upon the wafer alignment pattern 60a on the wafer 60 surface with its wavefront being unchanged. The incident light is reflectively diffracted by the wafer alignment pattern 60a and then passes again through the mask 68 in the form of a zero-th order transmission light, and finally is focused in the neighborhood of the point 78 to form a spot 78b of focused light, representing the wafer position. In the illustrated example, when the light diffracted by the wafer 60 forms a spot, the mask 68 functions merely as a transparent member.

The position of the spot 78b formed by the wafer alignment pattern 60a in the described manner represents a deviation $\Delta\sigma'$, in the plane perpendicular to the optical axis containing the point 78, of an amount corresponding to the amount of deviation $\Delta\sigma$ of the wafer 60 with respect to the mask 68.

In the illustrated alignment system, for detecting of the relative positional deviation, lights from wavefront transforming elements (physical optic element) such as a diffraction grating, a zone plate or hologram for example, that uses the property of light as a wave, are imaged on a predetermined plane independently of each other, and deviations from respective reference positions are measured.

In the conventional alignment system, however, a quantity distribution or an intensity distribution of light incident on a detector (sensor) is directly subjected to signal processing, and this raises the following problems:

(a) Unwanted light (noise light) components, other than wanted signal light, impinge on the sensor and are photoelectrically converged together with the signal light. Examples of such unwanted light are: background light such as scattered light having been scattered by the object, stray light produced within an optical system, and so on. To avoid the effect of the unwanted light, too large burden has to be applied to a sensor signal processing system. (b) It is not possible to make so large the size of the sensor to cover the measurement range. For example, where the position of light impinging on a sensor is to be detected for measurement of positional deviation, enlargement of the range of positional error measurement necessitates setting of a corresponding sensor size. The enlargement of the sensor size however leads to an increase in the total quantity of unwanted light impinging on the sensor, thus resulting in reduced signal-to-noise ratio.

In JP-A-61-278136 (abstracted in Patent Abstracts of Japan, Vol. 11, No. 138 (E-503) (2585) published 2 May 1987) there is disclosed a method of detecting the position of a pattern on a wafer in which a predetermined symmetry evaluation function is used to determine the centre of a light pattern reflected from the wafer.

In US-A-4728193 there is disclosed a system for determining the relative locations of a substrate and a mask each having diffraction gratings formed thereon. The gratings are chosen so as to optimise the amount of zero order diffracted light.

## SUMMARY OF THE INVENTION

It is accordingly a primary object of the present invention to provide a position detecting method and apparatus by which the effect of unwanted light can be avoided to ensure signal light processing with a high signal-to-noise ratio, and thereby to ensure high-precision detection of the position of an object.

These and other objects, features and advantages of the present invention will become more apparent upon a consideration of the following description of the preferred embodiments of the present invention taken in conjunction with the accompanying drawings.

According to a first aspect of the present invention there is provided a system for aligning a first and a second object with each other comprising:

light projecting means for irradiating the first and second objects with light;

detecting means for detecting the light intensity distribution in a predetermined detection plane, of light from the irradiated first and second objects impinging on the detection plane, said detecting means producing signals corresponding to the light intensities at different positions on the detection plane; said system being characterised in comprising:

processing means for processing each signal from said detecting means in accordance with a weight coefficient corresponding to the position or light intensity corresponding to that signal so as to determine the centre of gravity position of the light upon the detection plane;

determining means for determining the relative positional relationship of the first and second objects on the basis of the determined centre of gravity position; and

alignment means for aligning the first and second objects with each other.

According to a second aspect of the present invention there is provided a method of aligning a first and second object with each other comprising:

irradiating the first and second objects with light;

detecting the light intensity distribution in a predetermined detection plane of light from the irradiated first and second objects impinging on the detection plane so as to produce signals corresponding to the light intensities at different positions on the detection plane;

said method being characterised in comprising the further steps of:

processing each said signal in accordance with a weight coefficient corresponding to the position or light intensity corresponding to that signal so as to determine the centre of gravity position of the light upon the detection plane;

determining the relative positional relationship of the first and second objects on the basis of the determined centre of gravity position; and

aligning the first and second objects with each other.

## BRIEF DESCRIPTION OF THE DRAWINGS

Figures 1 and 2 are schematic representations, showing a known type alignment system.
Figures 3A - 3C are schematic representations, respectively, showing a first embodiment of the present invention.
Figure 3D shows a modified form of an optical system usable in the first embodiment.

Figure 3E is a schematic view of a light receiving means used in the first embodiment.

Figures 4A and 4B are schematic representations of a positional deviation detecting system and an interval measuring system, respectively, of the first embodiment.

Figure 5 is a schematic representation, illustrating the principle of interval measurement in accordance with the first embodiment.

Figures 6A and 6B are schematic representation, illustrating other examples of interval measurement, in accordance with the first embodiment.

Figure 7 is a perspective view, showing marks provided on a mask and a wafer, in accordance with the first embodiment.

Figures 8A and 8B are schematic representations, illustrating the projection on a Y-Z plane of a positional deviation measuring light and an interval measuring light, in the first embodiment.

Figure 9 is a flow chart showing a first example of data processing, to be made in the first embodiment.

Figures 10A and 10B are schematic and diagrammatic representations, for explicating another example of data processing to be made in the first embodiment.

Figures 11A and 11B are graphs, each representing a weight coefficient distribution according to another example of data processing to be made in the first embodiment.

Figure 12 is a schematic representation, illustrating the processing range of a sensor in accordance with another example of data processing, to be made in the first embodiment.

Figure 13 is a schematic representation, illustrating the processing range of a sensor in accordance with a further example of data processing to be made in the first embodiment.

Figures 14A and 14B each shows a weight coefficient distribution according to the Figure 13 example.

Figure 15 is a schematic representation of a major part of a second embodiment of the present invention.

Figure 16 is a schematic representation of another example of optical arrangement of an interval measuring system.

Figure 17 is a schematic and diagrammatic view of a major part of a third embodiment of the present invention.

Figure 18 shows an example of the pattern of a Fresnel zone plate.

Figure 19 is a graph showing intensity distribution of Fraunhofer diffraction light.

Figure 20 is a flow chart showing the sequence of signal processing in accordance with the third embodiment of the present invention.

Figure 21 is a graph showing the relationship between displacement of a light spot and a detection error.

Figure 22 is a schematic and diagrammatic view of a major part of a fourth embodiment of the present invention.

## DESCRIPTION OF THE PREFERRED EMBODIMENTS

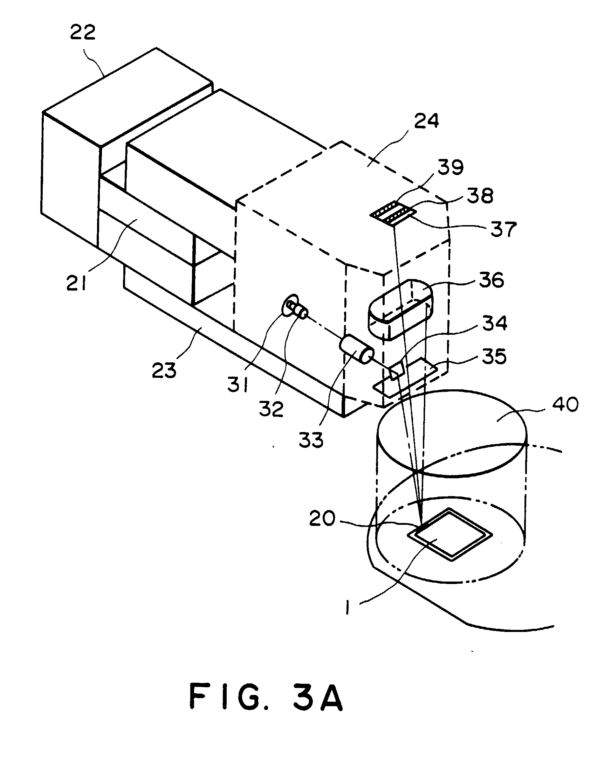

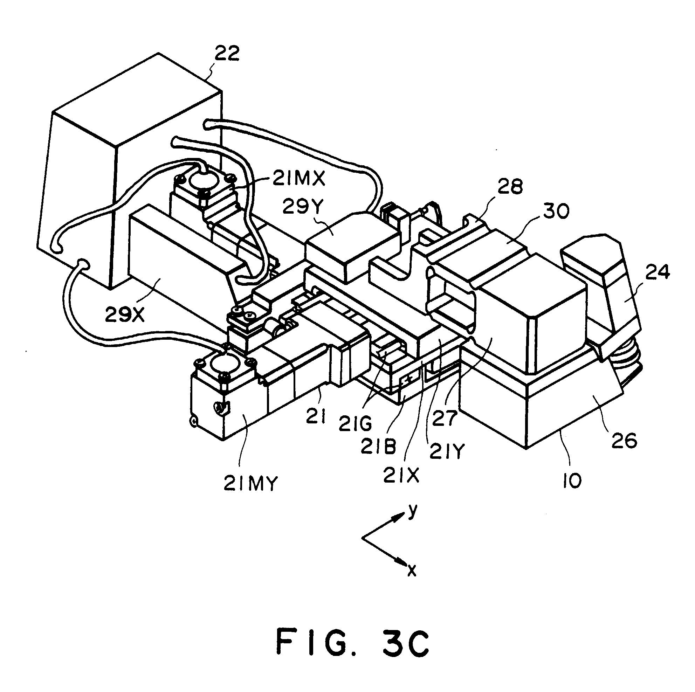

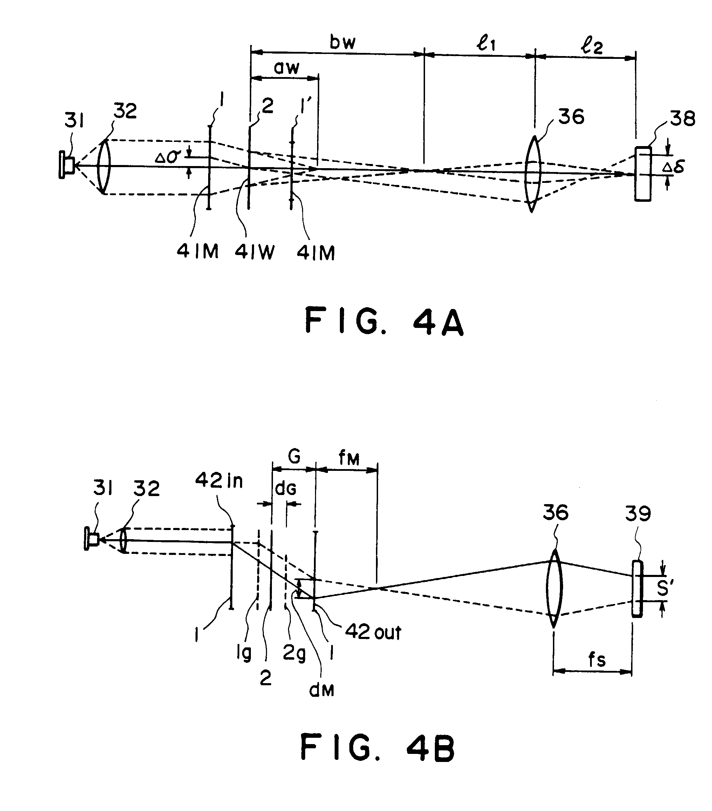

Figures 3A - 3C are schematic views of a first embodiment wherein the invention is applied to an exposure apparatus for manufacture of semiconductor devices. Figure 4A shows in an unfolded view the optical paths illustrated in Figure 3A.

In this embodiment, a light source 31 produces an electromagnetic wave. Hereinafter, this is called a "light". The light is collimated by a collimator lens 32 into a parallel light and, after passing a projecting lens 33 and a half mirror 34, the parallel light impinges, in an inclined direction, a first physical optic element 41M which may comprise, for example, a grating lens (one of Fresnel zone plates), provided on a first object 1 (mask M, for example).

The first physical optic element 41M has a converging function and emits a reflection light in a direction (-Z direction) of a normal to the first object 1. The emitted light impinges on a second physical optic element 41W which may comprise a grating lens, provided on a second object 2 (wafer W, for example) spaced from a predetermined distance from the first physical optic element 41M. The second physical optic element 41W has a diverging function and emits a light toward an alignment head 24. The emitted light is converged by a condensing lens 36 on, a detection surface of a detector 38. Output signal of the detector 38 is processed to obtain positional deviation between the mask 1 and the wafer 2 in a plane parallel to the mask and the wafer.

The mask 1 and the wafer 2 are held with a gap, within a predetermined range, maintained therebetween.

In this embodiment, the wafer 2 is moved for the alignment. However, a mask chuck moving mechanism may be provided to move the mask 1 for this purpose.

Hereinafter, for convenience, the first physical optic element 41M will be referred to as a "grating lens 41M" for the mask, while the second physical optic element 41W will be referred to as a "grating lens 41W" for the wafer. Also, the first object will be referred to as a "mask", and the second object will be referred to as a "wafer".

In the present embodiment, as described, the wafer 2 is provided with an alignment pattern which is formed by a grating lens (one of Fresnel zone plates) having a predetermined focal length, and a light for alignment inputted with inclination to the mask 1 surface from the alignment head 24 is deflected in the direction (-Z direction) of the normal to the mask 1 surface and is focused at a predetermined position (e.g., $Z = -187.0\ \mu m$).

In the present embodiment, the angle $\alpha$ of incidence of the light, inputted with inclination, on the mask 1 surface is preferably within a range of:

$$10 < \alpha < 80$$

The alignment pattern 41W on the wafer 2 comprises an off-axis type grating lens having a pattern which is asymmetric with respect to the Z axis. As an example, it is designed to provide a focal length of 217.0 μm, and is adapted so that the convergent (divergent) light transmissibly diffracted by the grating lens of the mask 1 is directed toward the alignment head.

Here, the alignment light is influenced by the lens function of the grating lens and is inputted to a photoreceptor 38 provided within the alignment head 24. In the first embodiment, the mask and the wafer are going to be aligned in respect to the direction of a scribe line in which the pattern is formed.

If in this structure the second object is laterally shifted (i.e. along the surface of the first or second object) by $\Delta\delta$ relatively to the first object, there occurs a change in the angle of emission of the emanating light, like a case where the coaxial relationship of lenses of an optical system is destroyed. The change in the angle of emission of the light causes corresponding shift of the center of gravity of a spot of the focused light on the detection surface 9. When the angle of emission is small and if the mask 1 and the wafer 2 are mutually deviated by an amount $\Delta\sigma$ in a direction parallel thereto, and where the distance from the wafer 2 to the point of convergence of the light reflected by the grating lens 41M of the mask 1 is denoted by aw while the distance to the point of convergence of the light passed through the grating lens 41W of the wafer 2 is denoted by bw, then, the displacement $\Delta\delta$ of the center of gravity of the light spot upon the detection surface 9 can be given by the following equation:

$$\Delta\delta = \Delta\sigma \times (bw/aw + 1) \tag{1}$$

Namely, the displacement $\Delta\delta$ of the center of gravity is of an amount magnified at an enlarging magnification of "b/a + 1".

If, as an example, a = 0.5 mm, and b = 50 mm, the deviation $\Delta\delta$ of the center of gravity is being magnified by 101 (one hundred and one) times larger, in accordance with equation (1).

It will be readily understood from equation (1) that the deviation $\Delta\delta$ of the center of gravity and the positional deviation $\Delta\sigma$ are in a proportional relationship. If the detector has a resolution of 0.1 μm, a position resolution of an order of 0.001 μm is obtainable with regard to the positional deviation $\Delta\sigma$.

More specifically, any positional deviation between the mask and the wafer can be detected in the following manner:

First, at the time of mask setting, a reference position is determined. For this reference position, the position of center of gravity of light on the sensor, as assumed when the mask and the wafer have no relative positional deviation, is selected. The determination of the reference position may be made on the basis of trial printing. Then, in the actual position detecting operation, any error in the position of the center of gravity of light from the reference position, in respect to the X-direction, in this embodiment, is measured. From the thus measured value and from the aforementioned proportional relationship, the relative positional deviation between the mask and the wafer can be determined.

In the present embodiment, the second object is moved in accordance with the positional deviation $\Delta\sigma$, obtainable by signal processing through an adjusting means (to be described later), whereby the first and second objects can be aligned with each other at high precision.

Here, the term "center of gravity of light" means such a point that, when in the cross-section of the light a position vector of each point in the section is multiplied by the light intensity of that point and the thus obtained products are integrated over the entire section, the integrated value has a "zero vector". As an alternative, the position of a peak point in the light intensity may be used as a representative.

Examples of a light source usable in this embodiment are: a light source such as, for example, an He-Ne laser, a semiconductor laser or otherwise that can provide light of high coherency; a light source such as, for example, a light emitting diode (LED), an Xe lamp (provided that a resist is insensitive to this), an Hg lamp or otherwise, that can provide light of low coherency.

Next, description will be made of measurement of the interval between the mask 1 and the wafer 2 in this embodiment and the subsequent alignment of them in a vertical direction, particularly with reference to a mask lens $A^2F$ method, by way of example.

The mask lens $A^2F$ method is a method wherein a grating or a grating lens for light reception and emission is prepared on a mask surface, and details of it are such as follows:

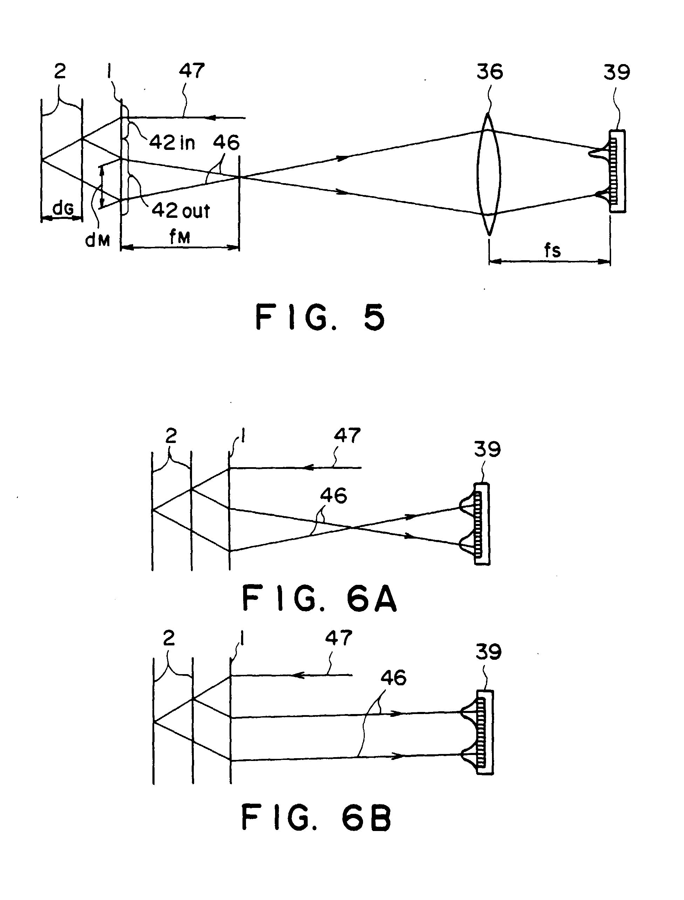

As shown in Figure 5, light 47 incident on a first pattern $42_{in}$ on the first surface (mask) 1 goes to a second surface (wafer) 2 with a predetermined angle defined with respect to a normal to the second surface 2. The light is specularly reflected by the second surface 2 and goes through a second pattern $42_{out}$ on the first surface 1. Here, the position (on the second pattern $42_{out}$) of passage of the light therethrough changes in accordance with the spacing between the first and second objects 1 and 2 (for a change $d_g$ in the spacing, a positional deviation $d_M$).

While the second pattern $42_{out}$ serves to direct the emanating light 46 toward a light spot position detecting sensor 39 (for the interval measurement), in addition to this, it has a function like that of a lens by which the angle of deflection for the emanating light is changeable with the position of incidence of the light upon the second pattern $42_{out}$ (focal length $f_M$).

Namely, in principle, the detector 39 can detect the emitted light 46 in the manner as illustrated in Figure 6A. However, as illustrated in Figure 6B, the angle of deflection for the light may be constant.

In other words, if, for example, a one-dimensional light spot position detecting sensor is placed at an appropriate position, it is possible to detect a change in the position of the light and, therefore, the described method applies directly. If, however, a light receiving lens 36 is used such as shown in Figure 5, the following merits result: That is, where light emanates somewhat divergently in the sense of physical optics and it tends to have an increasing beam diameter, it is possible to collect the light by the light receiving lens to form on the sensor 39 a sharp spot of high energy density. If the sensor 39 is set at the position of the focal point of the light receiving lens 36, having a focal length fs, then the system can detect only the angle of the light. Thus, the light receiving lens and the sensor can be combined in to an integral structure, and any positional deviation in a direction perpendicular to the optical axis of the lens does not affect the detection. However, even when it is not possible to set the sensor at the focal point position, for any reason, the structure is sufficiently practical provided that the effect of the positional deviation is in a small range that can be disregarded. Therefore, it is not necessary to limit the sensor position to the focal point position of the light receiving lens.

On the other hand, in Figure 5 the amount of displacement S of the spot on the sensor surface, for a unit change in the spacing (interval) can be given by:

$$S = (fs/f_M) \cdot d_M \tag{2}$$

Where the angle of the light emanating from the first pattern $42_{in}$, defined with respect to a normal to the second surface 2, is denoted by $\theta 1$, then the displacement S of the spot resulting from a change $d_G$ in the interval, from a reference interval, can be expressed as follows:

$$S = 2d_G \cdot (fs/f_M) \tan \theta 1 \tag{2'}$$

The mask and the wafer can be set at the reference interval, by using a separate known type interval measuring means. Thus, when the mask and the wafer are at the reference interval, the position of the center of gravity of light upon the sensor surface is detected and memorized, in preparation. In the actual interval detecting operation to be made just before the exposure operation, for example, any error S in the position of the center of gravity of the light spot, from the reference position, is measured and the thus measured value is substituted into equation (2') to determine $d_G$. From the thus determined error with respect to the reference interval, the current interval between the mask and the wafer can be determined.

In accordance with the principle described hereinbefore, the absolute amount of the spacing between the mask and the wafer can be measured. Therefore, when a wafer is supplied after the mask setting and if the wafer is set at an interval 100 µm which is larger than a desired interval 30 µm to be set, it is possible to detect with high precision the value of mask-to-wafer gap of 100 µm such that, on the basis of a measured value, they can be set at the desired mask-to-wafer interval 30 µm only by a single operation. Accordingly, high-speed gap (spacing) setting is ensured.

The components of the present embodiment will now be explained in detail, with reference to Figures 3A - 3C.

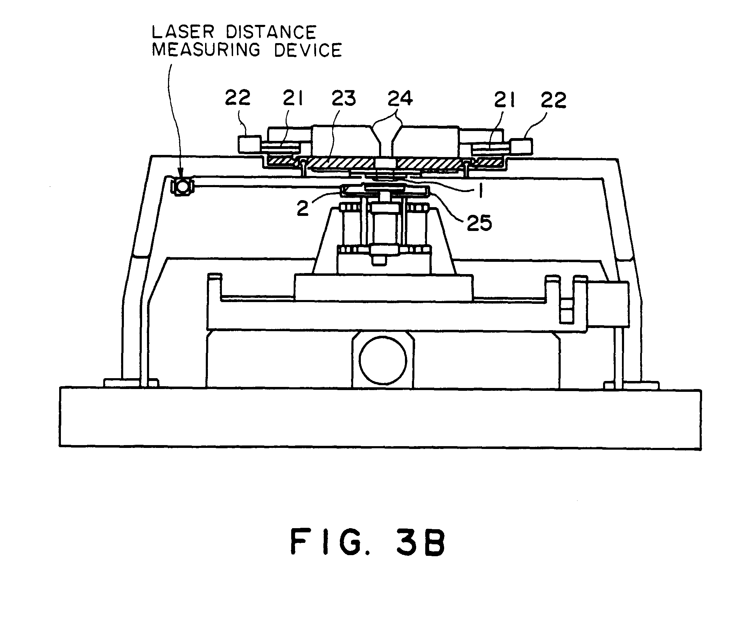

The light beam emanating from the alignment pickup head 24 (casing for accommodating therein a light source, sensor means and the like) is projected on a mark setting area 20 of each of the mask and the wafer 1 and 2, and the reflected or diffracted light goes back to the alignment pickup head 24. The alignment pickup head 24 is mounted to a stage 21, so that it can be moved two-dimensionally in accordance with the site of the alignment region. This movement is controlled by a stage controller 22. Here, the stage 21 is guided by a super-flat base plate 23, so as not to produce pitching and yawing. The stage controller 22 operates, at the time of initiation of the alignment and interval control, to actuate the stage 21 to move the head 24 to a position, memorized in preparation, for illumination and detection of evaluation marks 20 of the mask and the wafer. Figures 3B and 3C schematically show the stage 21 and a moving mechanism including components around the stage.

The moving mechanism will now be explained in greater detail. Figure 3C shows details of the stage and the stage controller. The alignment pickup head 24 is attached to a clamper 27 which is provided to press, against a super-flat base plate 23 at a constant pressure, a super-flat surface 10 of a support 26. The pickup head 24 is mounted to the upper part of a main frame of the alignment device, through the super-flat base 23. The clamper 27 is coupled through a parallel leaf spring means 30 to a movable support 28 which is provided on a two-dimensionally movable stage 21. The stage 21 comprises a base 21b, an X-direction slider 21X, a Y-direction slider 21Y, a guide means 21G for guiding the X-direction and Y-direction sliders, and drive sources 21MX and 21MY provided on the base 21B, for moving the sliders 21X and 21Y in the X direction and Y direction, respectively. The operation of these drive sources MX and MY is controlled by a controller 22 so as to shift the head 24 in these directions, for positioning the same at a desired site. The amount of movement of each stage can be measured precisely by means of laser distance measuring devices 29X and 29Y, the data obtained by the measurement being inputted to the controller 22. In response, the controller 22 detects the current position of the head 24 and supplies an instruction signal to each of the drive sources MX and MY so that the head 24 is displaced to the desired site. In this manner, the position of the head 24 is controlled precisely. After the head is moved to the position for detection, measurement of any lateral deviation and interval detection are executed in the manner described hereinbefore. In accordance with the result of measurement and detection, the wafer stage 25 is moved in an appropriate direction or directions to correct the lateral deviation and the error in the interval, whereby the alignment and interval control are accomplished. If necessary, the above-described operation is repeated.

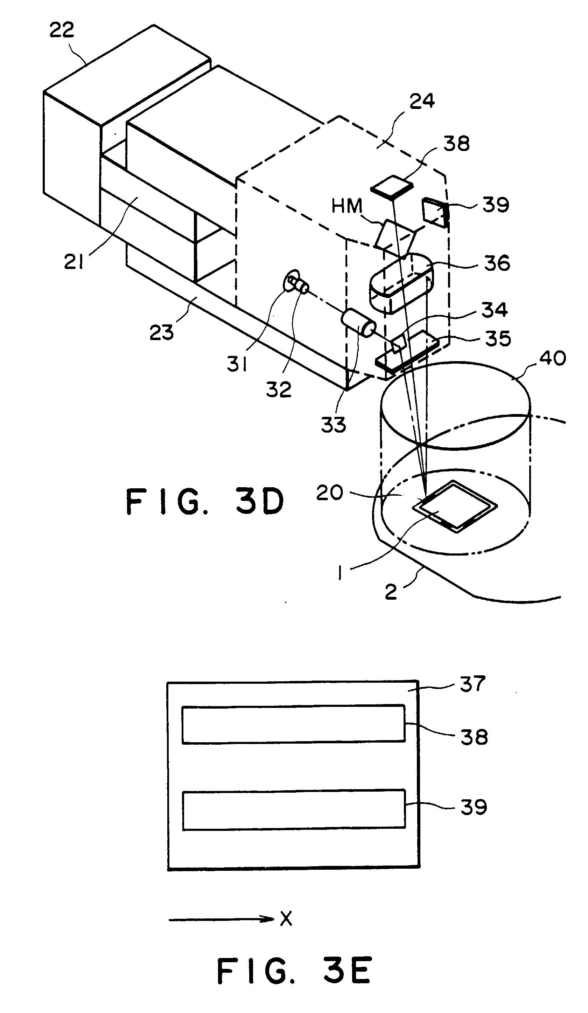

The alignment pickup head 24 accommodates therein a lateral deviation detecting system, an interval detecting system, a light projecting and receiving system and the like. Light beam emitted by a light source 31 (more particularly, a semiconductor laser in this embodiment) is projected through a collimator lens 32, a projecting lens 33 and a projecting mirror 34, to an evaluating mark 20. The light beam emanating from the mark is directed by a detection lens 36 to the detection system and impinges on a light receiving element 38 for lateral deviation detection and a light receiving element 39 for interval detection, provided on the same plane of a base plate 37 surface, whereby respective signals are obtained. The alignment pickup head 24 is equipped with a light projecting and receiving window 35 to which a filter is attached to block any of the light from an exposure light source. The light receiving elements 38 and 39 may be provided on separate planes, such as illustrated in Figure 3D, with the respective lights being guided by a half mirror HM. In the Figure 3D example, a lens 36 is used in common for the positional deviation detecting light and the interval detecting light, such that each of these lights produces good intensity concentration (focusing) upon a corresponding sensor 38 or 39. Thus, with this structure, the whole optical system can be reduced in size.

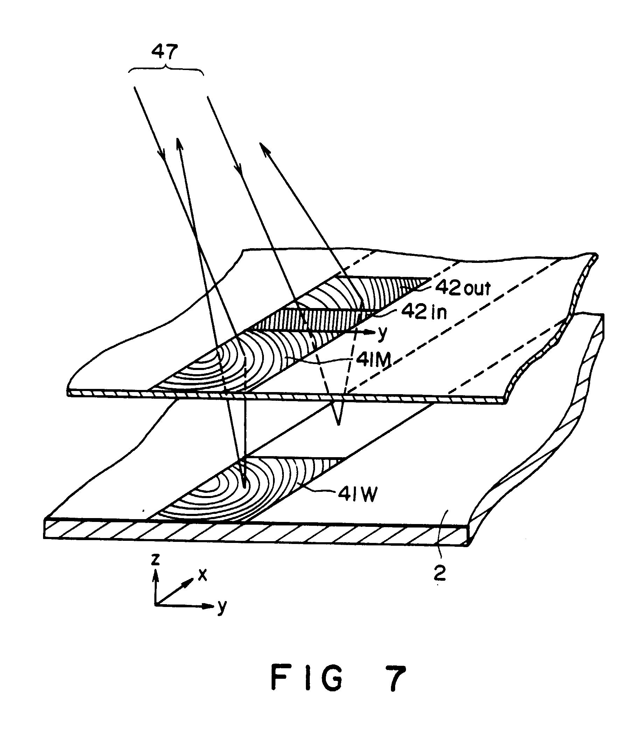

As for the evaluation mark means, as illustrated in Figure 7, the mask is provided with a mark 41M for the lateral deviation detection and marks $42_{in}$ and $42_{out}$ for the interval measurement, which marks are juxtaposed as illustrated. On the other hand, the wafer is provided with a mark 41W at a position corresponding to the mark 41M.

In the present embodiment, the device is designed so that the projected light 47 is in the form of a parallel light as it is incident on the evaluation mark, and is projected at the same time on the lateral deviation detecting mark 41M and the interval measuring mark $42_{in}$, both of which is at a light projection region.

In the lateral deviation detecting system, the mark 41M on the mask 1 surface has a converging function and, through the wafer mark 41W having a function for imaging the point of convergence at a position optically conjugate with the detection surface, any lateral deviation is magnified on the detection surface and is detected. The light receiving lens 36 provides a relay lens system for relaying the imaging point formed by the wafer mark 41W to the lateral deviation detecting light receiving element 38. Figure 4A shows this system in respect to the lens power arrangement.

On the other hand, the interval measuring system uses a mask lens $A^2F$ method described hereinbefore. The incident parallel light goes through the receiving mark $42_{in}$ for the interval measurement, provided on the mask, and is diffracted and deflected by this mark. Then, the light is specularly reflected by the wafer 2 surface (specular reflection surface) to a particular area on the emitting mark $42_{out}$ on the mask, which area corresponds to the mask-to-wafer interval. Then, it goes out the mask surface at an angle corresponding to the interval, and is directed to the interval measuring light receiving element. The position of incidence of the light upon this light receiving element 39 is changeable in accordance with equation (2).

Figure 4B shows this interval measuring system in respect to the lens power arrangement, like the case of the lateral deviation detecting system.

In the present embodiment, the lens 36 is used in common as a condensing lens 36 shown in Figure 4B and as a relay lens 36 shown in Figure 4A. Here, by making the effective distance $\underline{l}_2$ from the lens 36 to the sensor 38 surface in Figure 4A equal to the effective distance fs to the sensor 39 surface in Figure 4B, it is possible to set the sensors 38 and 39 on the same base plate 37.

As illustrated in Figure 3E, the sensors 38 and 39 are formed on the base plate 37 so that they are juxtaposed to be parallel to the X direction. If, on the other hand, the distance from the wafer 2 surface to the lens 36 is denoted by $\underline{l}$ the distance $\underline{l}$ may be set to satisfy the following relations:

$$\underline{l} = bw + \underline{l}_1$$

$$1/\underline{l}_1 = 1/fs = 1/\underline{l}_2 = 2/fs$$

It follows that:

$$\underline{l} = bw + fs/2 \tag{3}$$

If the distance $\underline{l}$ is initially determined, in this embodiment, then the value bw as determined by the focal lengths of the grating lenses 41M and 41W may be set to satisfy equation (3). Also, in this connection, the value aw may be set so that the amount of positional deviation between the mask 1 and the wafer 2 is magnified in accordance with equation (1). In the present embodiment, the sensors 38 and 39 are prepared simultaneously by the printing treatment made to the same base plate.

As an alternative, the sensor 38 for the signal light in the lateral deviation detecting system and the sensor 39 for the signal light in the interval measuring system may be disposed on the same base plate formed with a spherical surface of a radius R corresponding to the aberration of the detection lens 36. In that occasion, although a light projecting optical system and a light receiving optical system within an alignment pickup head may have a similar structure as of the first embodiment, disposition of the sensors 38 and 39 in this manner is effective to avoid any error in the measurement of the position of the center of gravity of light on a sensor, resulting from deformation of the point image, due to curvature of field or distortion of the detection lens 36.

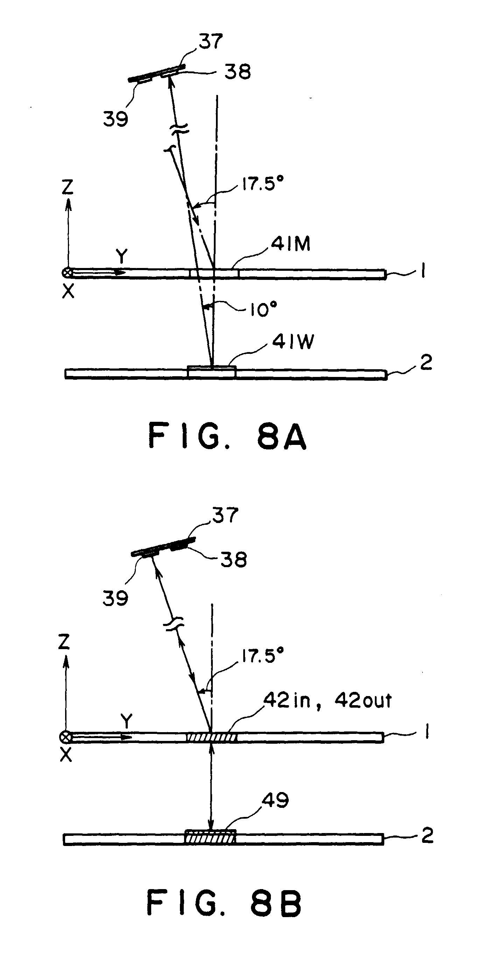

Figures 8A and 8B each shows an optical path as being projected on the Y-Z plane in Figure 7. Figure 8A depicts the optical path for the light for lateral positional deviation measurement, while Figure 8B depicts the optical path for the light for interval measurement. The light emanating from an unshown light source (semiconductor laser having a wavelength of 830 nm) is incidence with inclination on the mask 1 at an angle of 17.5 degrees. Thereafter, under the influence of the physical optic element 41M on the mask 1, the positional deviation measuring light goes in a direction substantially parallel to a normal to the wafer 2 surface (or parallel to a normal to the mask surface). On the other hand, the interval measuring light is deflected at a predetermined angle in the X direction, with respect to a normal to the wafer 2 surface.

After being influenced by the reflectively diffracting and reflecting functions of the physical optic elements 41W or. the wafer 2, these lights are separated along different optical paths having different emission angles, and they go out the wafer surface and impinge on the sensors 38 and 39, respectively. The physical optic elements 41M and 41W each is provided with a grating lens element having a predetermined focal length. Each mark has a size of 50 $\mu$m x 180 $\mu$m and is formed on a scribe line (or a region corresponding to this) adjacent a zone in which a semiconductor circuit pattern is to be printed.

Next, the diffracting function of the physical optic elements 41M, 41W and 42 of the mask 1 and the wafer 2, applied to the lateral positional deviation measuring light and the interval measuring light, will be explained.

The light projected with inclination on the mask 1 is influenced by the transmissive diffraction function of the grating lenses 41M and 42, such that there are produced various lights of different diffraction orders such as, for example, zero-th order, positive and negative first orders and positive and negative second orders. In this embodiment, positive first order transmissive diffraction light is used, for example. As regards the function of the grating lens, it has a positive lens function (converging function) where the order is positive, and it provides a concave lens function (light diverging function) where the order is negative.

The pattern of the grating lens 41M is designed so that the positive first order transmission light goes along an optical path which is parallel to the normal to the mask surface. On the other hand, the grating $42_{in}$ serves as a deflecting element, for deflecting the light in the X direction. In this embodiment, the lateral positional deviation measuring light is influenced by negative first order reflective diffraction function of the grating lens 41W on the wafer 2 (i.e. it is influenced by a concave lens function).

On the other hand, the interval measuring light is reflected at zero-th order by a blank (patternless) area on the wafer 2 and, as for the lateral positional deviation measuring light, a light passing at zero-th order the grating lens 41M of the mask 1 is used. In this manner, the lateral positional deviation measuring light after it is emitted from the light source is diffracted at positive first order (by convex lens function) by the grating lens 41M of the mask and again is diffracted at negative first order (concave lens function) by the grating lens 41W of the wafer and finally it is acted on by zero-th diffraction function when it passes again the mask.

The interval measuring light, after it is reflected at zero-th order by the specular reflection surface of the wafer, is diffracted again by the grating lens $42_{out}$ of the mask, whereby it is transformed into negative first order diffraction light.

In this embodiment, an absolute value of the diffraction order is limited to not more than 1. However, the present invention when it is embodied is not limited to this. Light having diffraction order of an absolute value not less than 2 may of course be used.

Next, taking the detector 38 as an example, description will be made of the manner of reducing, through an adjusting means, a decrease in detection precision where unwanted light is incident on a light receiving surface.

As an example, the detector 38 comprises a one-dimensional sensor (CCD linear sensor) of charge coupled type, based on photoelectric conversion, having picture elements of a number 2048 and a picture element size of 13x13 (micron). Electric charges produced by photoelectric conversion and then accumulated are transferred from the picture elements to a CCD shift register and, after passing a charge detecting portion, they are outputted to an output amplifier comprising a source follower. Thereafter, the light intensity corresponding to each picture element of the detector 38 is memorized into a waveform memory in the form of an electric signal and, after analog-to-digital conversion, data is transferred to a microcomputer. In the microcomputer, the transferred data corresponding to the light intensity at each picture element of the detector 38, having "256 tone", can be processed in the following manner:

(1) A first method is such that:

(1-1) The position So of the picture element which is at a point corresponding to the light intensity peak value of the data supplied to the microcomputer, is detected.

(1-2) The part of the data that concerns a zone, covering the opposite sides of the position So, having a width of picture elements of a number n, is multiplied by a weight coefficient of 1, whereas the remaining part of the data is multiplied by a weight coefficient 0.

(1-3) By using the data obtainable with execution of step (1-2), the position of the center of gravity of light is determined and then the position of such picture element that corresponds to the determined position is detected. The algorithm is such that: The data at (+m)-th picture element on the sensor as counted with respect to a reference picture element thereof is multiplied by a weight $\underline{m}$, together with its sign, and after the moment of each picture element as well as the total thereof are calculated, the resultant is divided by the sum of the data of all the picture elements, corresponding to the total light quantity in the region. The real number data obtainable by this division is multiplied by the size of the picture element in the positional deviation detecting direction, and a resultant represents the position of the center of gravity of light.

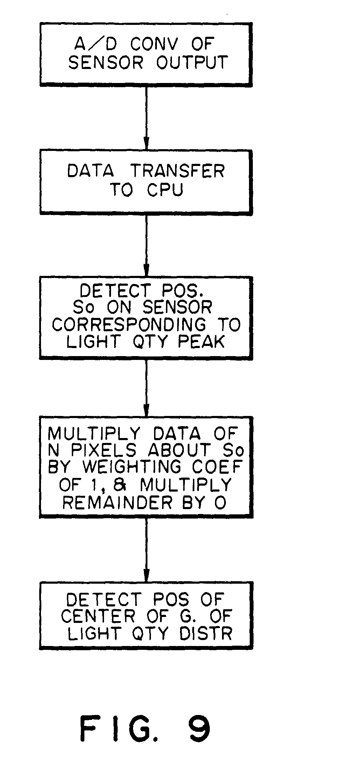

The flow chart of Figure 9 shows the procedure described above.

It can be said that in this example a rectangular window function of a size corresponding to the width of picture elements of a number n, about the peak position in intensity of light on the photoreceptor 38, is applied to each picture element data. As regards the width n for the picture elements, usually it may be determined by calculating, in preparation, the diameter of a light spot on the sensor which is determined by the size of the alignment mark and the power arrangement of the optical system as a whole, including the alignment mark.

(2) As a second method, the optical system may have a similar structure as of the first embodiment (Figure 3A), and the signal from the detector 38 may be processed in the following manner:

(2-1) The position So of the picture element that corresponds to a peak value in the light quantity of all the picture elements of the detector 38, is detected.

(2-2) The positions of those picture elements which include a point that satisfies $1/\alpha$ ($\alpha > 0$) of the peak value of the light intensity, are extracted. If three or more picture elements apply, those which are at the outermost positions from the picture element So are selected. That is, two picture elements such as (+m)-th and (-n)-th picture elements as counted from the picture element So, are selected.

(2-3) The part of the data concerning those picture elements which are in a range from the (+m)-th picture element to the (-n)-th picture element, about the picture element So, as determined by step (2-2), is multiplied by a weight coefficient of 1, whereas the remaining part is multiplied by a weight coefficient of zero.

(2-4) By executing a procedure similar to that made at step (1-3) according to the first method, the position of the center of gravity of light is determined.

In this example, like the first example, a rectangular window (particularly in respect to the width and position thereof) is determined on the basis of the light intensity distribution of the signal light on the detector 38.

(3) A third method is that the optical system is structured in the same way as of the first embodiment (Figure 3A) and the signal from the detector 38 is processed in the following manner:

(3-1) The position So of the picture element that corresponds to a peak value of the intensity of light received by the picture elements of the detector 38, is detected.

(3-2) The part of the data concerning those picture elements corresponding to a distance x about the picture element So, is multiplied by a weight coefficient which can be given by the following equation:

$$W(x) = [2J_1(kax)/kax]^2$$

wherein $J_1$ with parenthesis is a first type Bessel function of first order, and

$$k = 2\pi/\lambda b$$

wherein $\lambda$ is the wavelength of light, and b is the distance from the alignment mark to the detector 38. Also, a denotes the aperture size of the alignment mark.

(3-3) By executing a procedure similar to the procedure (1-3) of the first method, the position of the center of gravity of light is determined.

As described with reference to this example, the weight coefficient for the picture elements may be a predetermined function corresponding to the position of the picture element on the sensor.

For example, rather than a rectangular window function as can be depicted in the form of a rectangle with the axis of abscissa representing the position and with the axis of ordinate representing the coefficient, a trapezoidal window function, a triangular window function, a Gaussian distribution function, a zinc $Sinc^2$ function may be used. The parameter which defines the width of such a function may be determined on the basis of the diameter of the light beam on the detector 38, if it is predetected. Alternatively, it may be determined from the light quantity distribution on the detector 38, in accordance with the procedure described with reference to the second method.

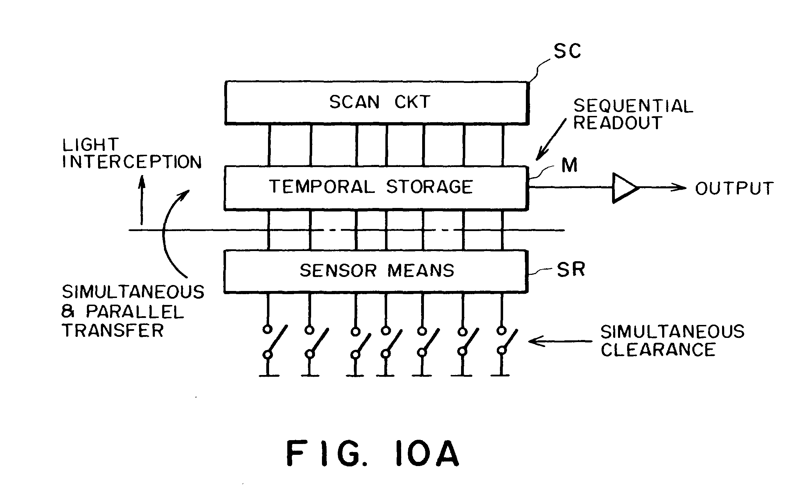

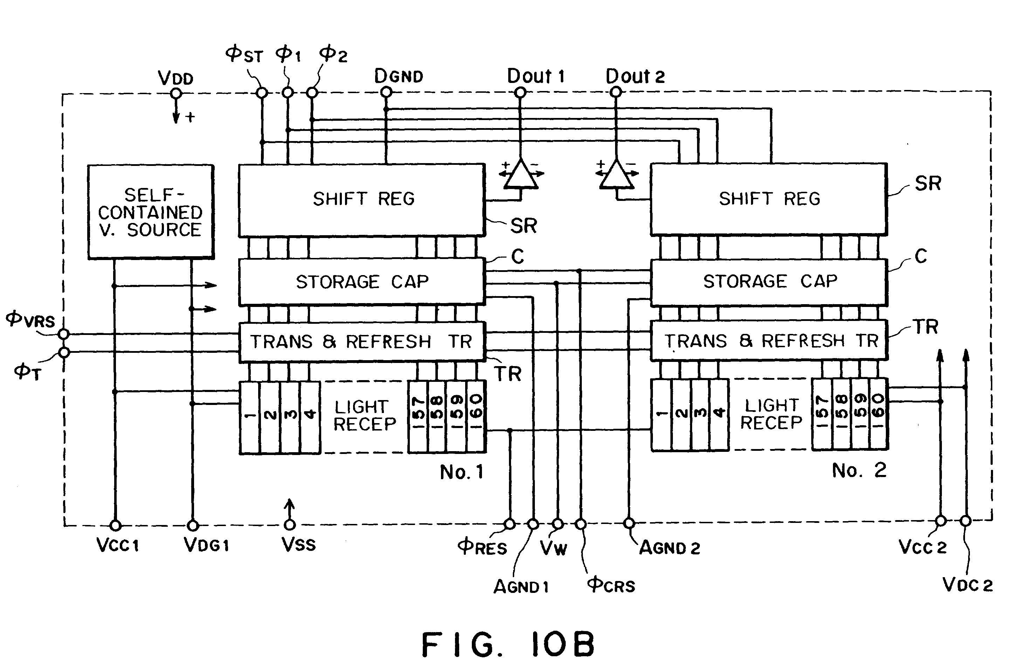

(4) A fourth method uses a sensor having switching means for each picture element, such as shown in Figures 10A and 10B.

As an example, in the alignment optical system shown in the first embodiment (Figure 3A), the detector may comprise two line sensors 38 and 39 which are adapted to receive a positional deviation signal light and an interval signal light, respectively.

Figure 10A is a schematic representation, illustrating the structure and operation of the sensor, wherein denoted at SR is sensor means, at M is a temporal storage and at SC is a scanning circuit. Figure 10B illustrates details of the structure of the sensor means. Positional deviation signal receiving sensor (sensor No. 1) and interval signal light receiving sensor (sensor No. 2) operate at the same timing. These line sensor are scanned in the same direction and produce outputs at the same time. The "ON/OFF control" of the output of each picture element is made by a transfer refresh transistor TR shown in Figure 10B. Also, the "ON/OFF control" of the output of each picture element signal by the transistor TR can be preset by using a signal $\phi_{VRS}$ as supplied from the microprocessor.

In this example, at the time of mask-to-wafer gap setting, the transistors TR associated with the picture elements of the light receiving portion of the line sensor No. 1 are set to "OFF state", in preparation, by means of the microprocessor. On the other hand, the transistors TR corresponding to the picture elements of the light receiving portion of the line sensor No. 2 are set to "ON state". The outputs of the picture elements of the line sensor No. 2, receiving the interval signal light, are transferred through a storage capacitance C and a shift register SR to the microprocessor. In response, the microprocessor determines the central position, the width and the like of a rectangular window function to be set in respect to (the picture elements) the line sensor 2 in accordance with the procedure described with reference to the first example or second example. Based on this, the microcomputer supplies the "ON/OFF information" of each transistor TR, in the form of a signal $\phi_{VRS}$. The thus obtained signal from the line sensor No. 2 is processed by the algorithm according to the mask $A^2F$ method, described hereinbefore, and the interval setting is done.

Next, for detection of relative lateral deviation (positional error) between the mask and the wafer as well as the corrective control therefor, the transistors TR for the line sensor No. 1 are set to "ON state", while the transistors TR for the line sensor No. 2 are set to "OFF state". Like the interval setting, the light quantity distribution data of the positional deviation signal light from the line sensor No. 1 is transferred to the microprocessor. In accordance with the procedure described with reference to the first or second method, the microprocessor determines the central position, the width and the like of a rectangular window function to be set on the line sensor No. 1. Based on this, the "ON/OFF information" of the transistors is supplied in the form of a signal $\phi_{VRS}$, whereby the switches are opened/closed. By using the thus obtained signal from the line sensor No. 1 and in accordance with the algorithm of the procedure (1-3) of the first method, the position of the center of gravity of the light intensity distribution of the positional deviation signal light, on the sensor, is determined.

(5) A fifth method is that: the alignment optical system and mechanical system are structured such as described with reference to the first embodiment (Figures 3A - 3C), and the microcomputer processes the data, transferred thereto, corresponding to the light intensities at the picture elements of the detector 38 of "256 tone", in the following manner:

(5-1) The position So of the picture element which is at a point corresponding to the light intensity peak value of the data supplied to the microcomputer, is detected.

(5-2) The part of the data that concerns a zone, covering the opposite sides of the position So, having a width of picture elements of a number n, is multiplied by a weight coefficient of 1, whereas the remaining part of the data is multiplied by a weight coefficient 0.

(5-3) By using the data obtainable with execution of step (5-2), the position of the center of gravity of light is determined and then the position of such picture element that corresponds to the determined position is detected. The algorithm is such as shown in Figure 9 that: The data at (+m)-th picture element on the sensor as counted with respect to a reference picture element thereof is multiplied by a weight $\underline{m}$, together with its sign, and after the moment of each picture element as well as the total thereof are calculated, the resultant is divided by the sum of the data of all the picture elements, corresponding to the total light quantity in the region. The real number data obtainable by this division is multiplied by the size of the picture element in the positional deviation detecting direction, and a resultant represents the position of the center of gravity of light.

It can be said that in this example a rectangular window function of a size corresponding to the width of picture elements of a number n, about the peak position in intensity of light on the photoreceptor 38, is applied to each picture element data. As regards the width n for the picture elements, like the first example, usually it may be determined by calculating, in preparation, the diameter of a light spot on the sensor which is determined by the size of the alignment mark and the power arrangement of the optical system as a whole, including the alignment mark. Alternatively, it may be made in accordance with the procedure of the second example, such as follows, to obtain the gravity center position of the positional deviation signal light. That is:

(5-1') The position So of the picture element that corresponds to the gravity center of the light of all the picture elements of the detector 38, is detected.

(5-2') The positions of those picture elements which include a point that satisfies $1/\alpha$ ($\alpha > 0$) of the peak value of the light intensity, are extracted. If three or more picture elements apply, those which are at the outermost positions from the picture element So are selected. That is, two picture elements such as (+m)-th and (-n)-th picture elements as counted from the picture element So, are selected.

(5-3') The part of the data concerning those picture element which are in a range from the (+m)-th picture element to the (-n)-th picture element, about the picture elements So, as determined by step (5-2'), is multiplied by a weight coefficient of 1, whereas the remaining part is multiplied by a weight coefficient of zero.

(5-4') By executing a procedure similar to that made at step (1-3) according to the first method, the position of the center of gravity of light is determined.

The weight coefficient is not limited to "0" or "1", as in the above-described procedures (5-2) and (5-2'). A weight function which is in the form of a function about the picture element So, as in the third method, may be used.

(6) A sixth method is that: the alignment optical system is structured like the optical system shown in the first embodiment, and the output of the detector 38 is processed in the following manner.

(6-1) The position So of the picture element that corresponds to the light intensity peak value or to the position of the center of gravity of light, of the data supplied to the microprocessor is detected.

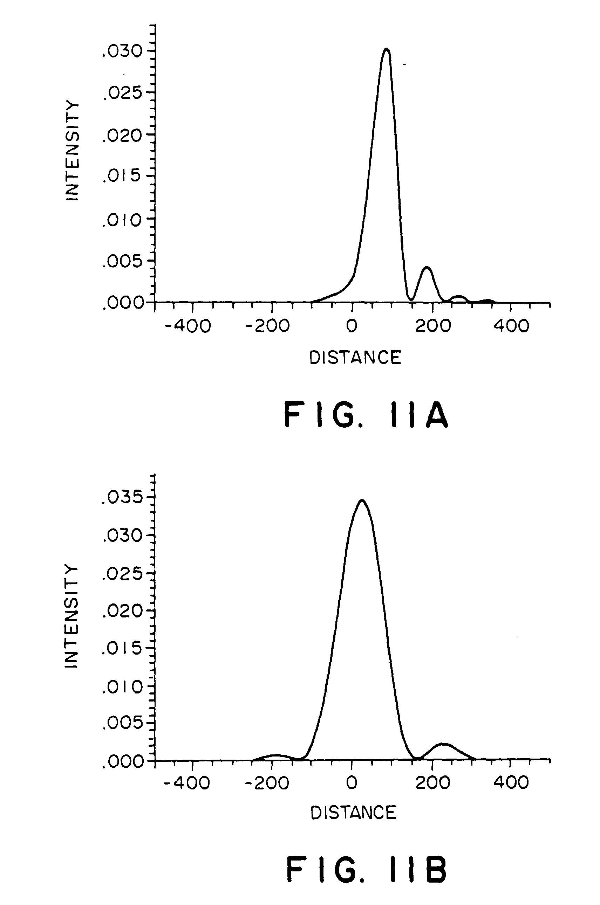

(6-2) The output data of each picture element is multiplied by a weight coefficient corresponding to the distance from So, which is in the form of a function such as illustrated in Figures 11A and 11B.

(6-3) From the data obtained at step (6-2) and by executing a procedure like the procedure (1-3) of the first method, the position of the center of gravity of light is determined.

In this example, as described, the light intensity distribution data of the signal light is multiplied, in accordance with the position of each picture element, by the weight function of an asymmetric distribution such as shown in Figures 11A and 11B. The form of the weight coefficient distribution function, to be used for the multiplication, is determined definitely by the amount and direction of the positional deviation, for example.

For the measurement of a positional deviation based on measurement of the position of the center of gravity of light which displaces on a sensor at a predetermined positional deviation enlarging magnification, determined by the power arrangement of a lens element (grating lens) provided on an object to be aligned, as in the first embodiment, it is known that the intensity distribution of the light on the sensor has an asymmetric shape due to aberrations of the grating lens system corresponding to the positional deviation (such as coma, astigmatism, distortion, wave-optic aberration peculiar to the grating lens, and the like). However, with regard to the function form of the above-described asymmetric function, the light intensity distribution data obtainable from simulation or experiments may be processed in preparation by smoothing, for example, and it may be multiplied, if necessary, by a rectangular window function as described with reference to the first and second methods, and the thus obtained data may be used.

The light intensity distribution data shown in each of Figures 11A and 11B is the result of simulation corresponding an output data from an accumulation type photoelectric converting CCD sensor, having picture elements of a number 600 and a picture element size of 13x13 (micron), where the positional deviation is of an amount 8 µm (Figure 11A)

and 1 μm (Figure 11B). Where the function form of the illustrated light intensity distribution data is to be used as a distribution function for the weight coefficient, the position of such point that corresponds to the light intensity peak value of the data as supplied to the microprocessor from the detector 38 or, alternatively, a first order approximation value of the positional deviation from the position of the center of gravity of the light may be detected. In accordance with the deviation of the approximated position, distribution data of the weight coefficient as predetected is appropriately translationally shifted in a lateral direction so that the positions of the light intensity peak points of the two data coincide with each other, and the multiplication may be made thereafter.

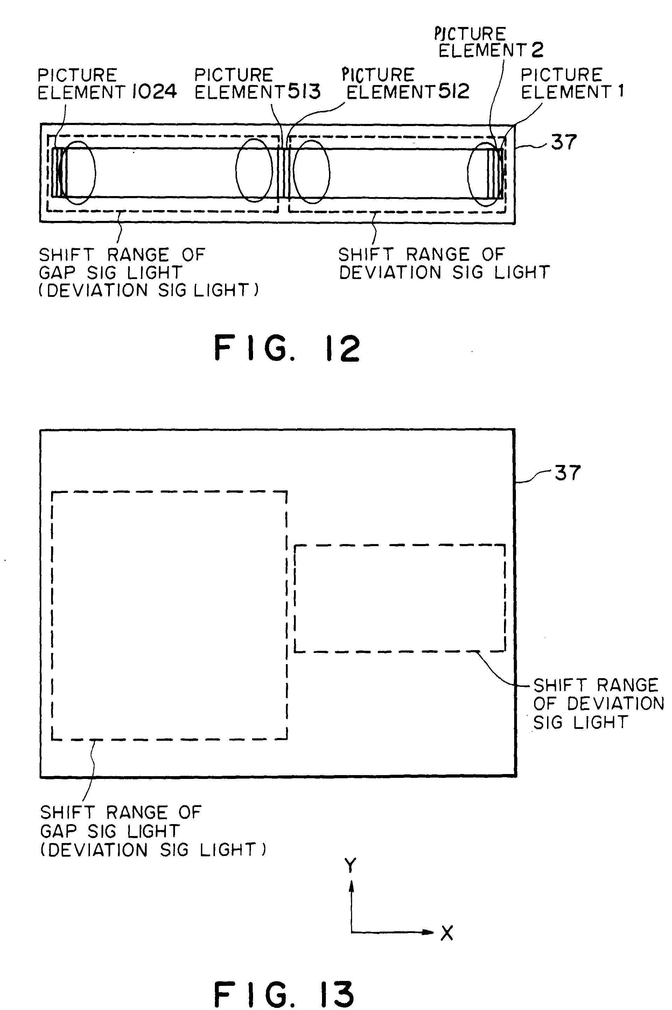

(7) A seventh method is that: the alignment optical system and the mechanical system are structured such as described with reference to the first embodiment (Figures 3A - 3C), and the detecting means for receiving the positional deviation signal light and the interval signal light comprises a single, one-dimensional sensor such as a CCD line sensor, for example. The marks provided on the first and second objects, to be aligned with each other, for the alignment purpose and for the interval setting purpose, are designed to have measurement ranges of 0 - ±15 μm and 20 - 90 μm, respectively. Also, they are set so that, in the respective measurement ranges, the light is displaceable on the sensor within an extent such as shown in Figure 12.

Where the extent of displacement of the light on the sensor is predetermined, as in this example, for the interval setting the outputs of the picture elements in the positional deviation signal light receiving region are multiplied by a weight coefficient of "0", while the outputs of the remaining picture elements are multiplied by a weight coefficient of "1". Thereafter, the procedure of any one of the first to sixth methods described hereinbefore, is performed. For the measurement of the positional deviation to be made after completion of the interval setting, the outputs of the picture elements in the interval signal light receiving region are multiplied by a weight coefficient of "0", while the outputs of the remaining picture elements are multiplied by a weight coefficient "1" and, thereafter, similar procedure is performed.

As an alternative, if the arrangement is such that time series data corresponding to the outputs of the picture elements of the sensor is produced in sequence, in an order from the picture element 1 to the picture element 1024 shown in Figure 12, once the time $t_0$ of start of the data output from the sensor is determined, then the time $t_1$ of the start of output of a corresponding picture element within the displaceable range of the signal light as well as the time $t_2$ of the termination of the output can be determined. Therefore, the structure may be made so that by the hardware the data is transferred to the microprocessor in the time period range of $t_1 - t_2$.

(8) An eighth method is such that: the alignment optical system and the mechanical system are structured such as the first embodiment (Figures 3A - 3C), and the detecting means for receiving the positional deviation signal light and the interval signal light comprises a single, two-dimensional sensor such as a CCD area sensor, for example.

The marks for the alignment and for the interval setting are designed and disposed so that, within a predetermined measurement range, each light produces a light intensity distribution range on the two-dimensional sensor, such as shown in Figure 13.

Where the extent of displacement of the light on the sensor is predetermined, as described, like the seventh method, for the interval setting the outputs of the picture elements in the positional deviation signal light receiving region are multiplied by a weight coefficient of "0", while the outputs of the other picture elements are multiplied by a coefficient of "1". Thereafter, the procedure of any one of the first to sixth methods is made. For measurement of the positional deviation, to be made after completion of the interval setting, the outputs of the picture elements in the interval signal light receiving region are multiplied by a weight coefficient of "0" while the outputs of the other picture elements are multiplied by a weight coefficient of "1". Then, a similar procedure is made.

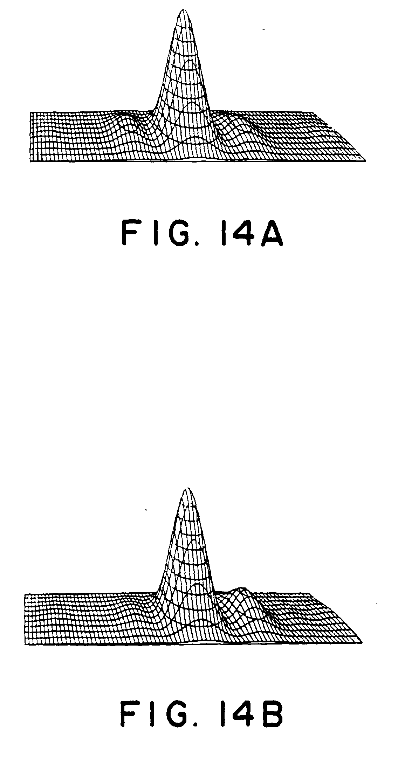

Subsequently, at each stage of alignment or interval setting, the data from those picture elements of the two-dimensional sensor, which are in a predetermined range, are multiplied by a weight coefficient distribution function such as shown in Figure 14A or 14B. In the illustrated examples, the height of the curved surface represents the magnitude of the weight coefficient at that position.

For the measurement of a positional deviation based on measurement of the position of the center of gravity of light which displaces on a sensor at a predetermined positional deviation enlarging magnification, determined by the power arrangement of a lens element (grating lens) provided on an object to be aligned, as in the first embodiment, it is known that the intensity distribution of the light on the sensor has an asymmetric shape due to aberrations of the grating lens system corresponding to the positional deviation (such as coma, astigmatism, distortion, wave-optic aberration peculiar to the grating lens, and the like). However, with regard to the function form of the above-described asymmetric function, the light intensity distribution data obtainable from simulation or experiments may be processed in preparation by smoothing, for example, and it may be multiplied, if necessary, by a rectangular window function as described with reference to the first and second methods, and the thus obtained data may be used.

The light intensity distribution data shown in each of Figures 11A and 11B is the result of simulation corresponding an output data from an accumulation type photoelectric converting CCD sensor, having picture elements of a number 600 and a picture element size of 13x13 (micron), where the positional deviation is of an amount 8 μm (Figure 11A) and 1 μm (Figure 11B). Where the function form of the illustrated light intensity distribution data is to be used as a distribution function for the weight coefficient, the position of such point that corresponds to the light intensity peak value of the data as supplied to the microprocessor from the detector 38 or, alternatively, a first order approximation value of the positional deviation from the position of the center of gravity of the light may be detected. In accordance with the deviation of the approximated position, distribution data of the weight coefficient as predetected is appropriately translationally shifted in a lateral direction so that the positions of the light intensity peak points of the two data coincide with each other, and the multiplication may be made thereafter.

Further, with regard to the processing of the signal from the two-dimensional sensor, it is a possible alternative that, of all the light intensity distribution data corresponding to the lines in the X direction shown in Figure 13, those line data including a relatively small amount of unwanted light such as scattered light, are extracted and, in regard to each line data, the position of the center of gravity of light is detected in accordance with the algorithm described with reference to the first method, for example. Then, the averaging of those data of the gravity centers, the averaging with weight coefficient to the predetermined lines, the square averaging or otherwise, is performed to determine the position of the center of gravity of light on the sensor.

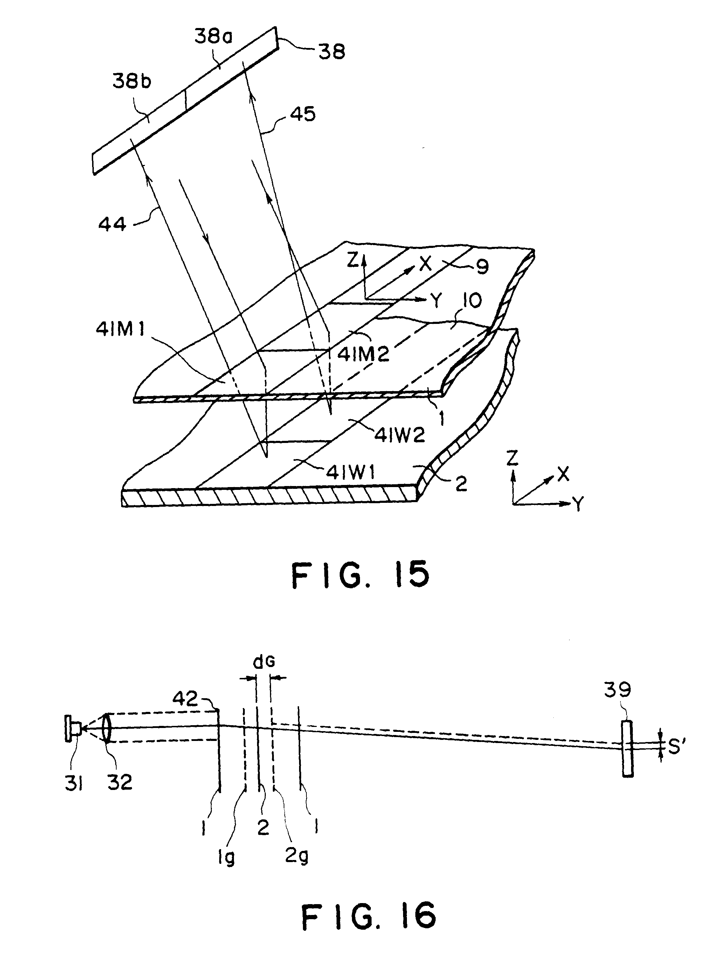

Figure 15 is a schematic representation of the major part of a second embodiment of the present invention. Like numerals as of the foregoing embodiment are assigned to similar or corresponding elements. Alignment marks 41M1 and 41W1 are provided on a mask 1 and a wafer 2, respectively, for obtaining first signal light. Alignment marks 41M2 and 41W2 are provided on the mask 1 and the wafer 2, respectively, in juxtaposition with the alignment marks 41M1 and 41W1, respectively, for obtaining second signal light. Each of these alignment marks 41M1, 41W1, 41M2 and 41W2 comprises a grating lens such as, for example, a one-dimensional or two-dimensional Fresnel zone plate, and is provided on a scribe line 9 or 10 defined on the mask 1 surface or the wafer 2 surface. Numeral 44 denotes the first signal light (alignment light), and numeral 45 denotes the second signal light. The light denoted at 44 and 45 emanates from a light source (not shown) provided in an alignment head (not shown), and is collimated into a predetermined beam diameter.

Sensor 38 comprises a photoelectric converting element having a first detecting portion 38a and a second detecting portion 38b. The sensor 38 is formed by a one-dimensional CCD sensor, for example, and receives the alignment light 44 and 45.

In the present embodiment, the alignment light 44 and 45 is incident on the alignment marks 41M1 and 41M2 of the mask at a predetermined angle and is transmissibly diffracted by these marks. Then, the light is reflectively diffracted by the alignment marks 41W1 and 41W2 on the wafer 2 and impinge on the sensor 38. By this sensor 38, the position of the center of gravity of the inputted alignment light is detected and, by using output signals of the sensor 38, the mask 1 and the wafer 2 are aligned with each other.

The sensor 38 receives plural signal lights such as illustrated in Figure 12. The sensor output signals are processed substantially in the same manner as having been described with reference to the eighth method, with the exception that plural positional deviation signal lights are inputted to the same sensor.

Description will now be made of the alignment marks 41M1, 41M2, 41W1 and 41W2.

The alignment marks 41M1, 41M2, 41W1 and 41W2 are provided by Fresnel zone plates (or grating lenses) having different focal lengths. For practical use, each mark has a size of 50 - 300 μm, in the lengthwise direction of the scribe line and 20 - 100 μm in the widthwise direction (Y direction) of the scribe line.

In this embodiment, both of the alignment lights 44 and 45 are incident on the mask 1 at an angle of incidence of about 17.5 degrees, with the projection upon the mask 1 surface being perpendicular to the scribe line direction (X direction).

The alignment lights 44 and 45 incident on the mask 1 with the predetermined angle are influenced by the lens functions of the grating lenses 41M1 and 41M2, such that each is transformed into a convergent or divergent light which is emitted from the mask 1 so that its chief ray has a predetermined angle with respect to the normal to the mask 1.

The alignment lights 44 and 45 having been transmissibly diffracted at first order by the alignment marks 41M1 and 41M2, are focused at a point of distance 184.43 μm vertically below the wafer 2 surface and a point of distance 186.57 μm vertically above the wafer 2 surface, respectively. The alignment marks 41M1 and 41M2, in this case, have focal lengths of 214.43 μm and -156.57 μm, respectively. Also, the mask 1 and the wafer 2 are spaced by a distance 30 μm.

The light (first signal light) having been transmissibly diffracted by the alignment mark 41M1 is influenced by a concave lens function of the alignment mark 41W1 on the wafer 2, and is collected on the sensor 38 surface (first detecting portion). On this sensor 38 surface, at this time, the light is incident with any relative positional deviation (i. e. any misalignment of the axes) of the alignment marks 41M1 and 41W1 being magnified, with a result of corresponding shift of the position of the center of gravity of the incident light. The principle of this is the same as that of the foregoing embodiment.

The present embodiment is so set that, when the mask 1 and the wafer 2 have no relative positional deviation (i. e. when the alignment marks 41M1 and 41W2 on the mask 1 and the wafer 2 just provide a coaxial system), the chief ray of the alignment light emitting from the wafer 2 has an angle of emission of 13 degrees, and the projection of the emitted light on the wafer 2 surface extends with an angle of -5 degrees with respect to the widthwise direction (Y direction) of the scribe line and, additionally, the emitted light is focused on the sensor 38 surface which is disposed at a predetermined position, for example, at a height of 18.657 mm from the wafer 2 surface.

On the other hand, the light (second signal light) transmissibly diffracted by the alignment mark 41M2 is influenced by the alignment mark 41W2 and is emitted so that lateral deviation of an imaging point is shifted in a direction different from that of the first signal light and that the projection of the emitted light on the wafer 2 surface extends with an angle +5 degrees with respect to the widthwise direction of the scribe line and, additionally, the emitted light is collected at a point on the sensor 38 surface (second detecting portion).

With the described lens parameters of the alignment marks, for a relative positional deviation between the first and second objects 1 and 2 the gravity centers of the two signal lights on the detecting portions can displace by an amount one hundred (100) times larger than the amount of the relative positional deviation and, additionally, they displace in opposite directions. Namely, deviation enlarging magnifications "$\beta_1 = -100$" and "$\beta_2 = +100$" are obtained. Therefore, the spacing between the gravity centers of these lights can change by an amount two-hundred (200) times larger than the amount of the relative positional deviation between the two objects. In the present embodiment, by using the sensor 38, any error in the spacing between the gravity centers of the two lights with respect to a predetermined reference interval (which is the interval between the gravity centers of the two lights as assumed when the two objects have no relative positional deviation), is detected. Then, on the basis of the proportional relationship between (i) the amount of change in the spacing between the gravity centers of the lights and (ii) the amount of relative positional deviation between the two objects, which is predetected, the relative positional deviation between the first and second objects is measured. In this case, the sensor output signals may be processed in accordance with the eighth method described hereinbefore, and the first detecting portion 38a and the second detecting portion 38b are used to detect the gravity centers of the two lights, respectively.

The arrangement of the present embodiment wherein two signal lights can displace in the opposite directions, provides an advantage that, if the precision of setting the interval $\delta$ between the first and second objects 1 and 2 is not so high, the deviation enlarging magnifications $\beta_1$ and $\beta_2$ for calculation of the positional deviation are in a mutually compensating relationship in two optical paths. If, for example, the interval $\delta$ between the first and second objects 1 and 2 has increased from 30 $\mu$m to 33 $\mu$m, the magnification $\beta_1$ changes from -100 to -101.670 and the magnification $\beta_2$ changes from +100 to +98.433. As a result, the overall magnification "$|\beta_1| + |\beta_2|$" used for the calculation of the positional deviation changes from 200 to 200.103. Accordingly, in terms of proportion, the change can be reduced to a magnification change of 0.0517 %. This means that the changes in the respective signals by 1.67 % and 1.57 % can be suppressed to about 1/30. Therefore, when the invention is applied to such a system wherein the interval setting is difficult, the arrangement of the present embodiment provides an advantageous effect of directly enlarging the detection range or increasing the detection accuracy.

An additional advantageous effect is that, if the second object 2 comprises a reflection surface, any error due to the inclination of the same can be compensated for, in principle.

If, in this embodiment, the wafer 2 surface is inclined within an X-Z plane (Figure 13) by an amount 1 mrad, there occurs on the sensor 38 a displacement of about 37.3 $\mu$m of the center of gravity of the first signal light. On the other hand, since the second signal light 45 is symmetric with the signal light 44 with respect to a normal to the mask surface and they go along the optical paths of the same length, on the sensor 38 there occurs displacement of the center of gravity of the second signal light 45 as exactly the same as the first signal light. Thus, by processing in the sensor system the signals from the sensors (detecting portions) so as to detect and output a difference between those signals representing the positions of the effective gravity centers, the output signal from the sensor system does not change even if the wafer surface is inclined within the X-Z plane.

If, on the other hand, the wafer is inclined within a Y-Z plane, both of the two signal lights 44 and 45 cause shift of the gravity centers in the widthwise direction perpendicular to the lengthwise direction of the sensor. However, this widthwise direction is perpendicular to the direction along which the center of gravity of light displaces with a positional deviation to be detected on the sensor. Therefore, without the two lights, any alignment error can be avoided in effect.

Further, when the position of an alignment head accommodating therein an alignment light source, a light projecting lens system, sensors and the like, changes relatively to the mask-wafer system, there occurs a change in a one-to-one relationship. For example, if the head is displaced by 5 $\mu$m in the Y direction relatively to the mask, on the sensor 38 there occurs displacement of the effective gravity center of the signal light by 5 $\mu$m and, simultaneously, on the sensor 38 there occurs displacement of the center of gravity of the reference light by exactly the same amount of 5 $\mu$m.

Therefore, no change occurs in the final output of the sensor system, namely, in the differential signal representing the difference between the outputs concerning the gravity center positions of the first and signal lights.

It will be readily understood that any change in the position in respect to the X-axis direction does not result in an essential alignment error, even when both of the two lights are used.

In order to provide deviation enlarging magnification of opposite signs, in this embodiment the power arrangement of the alignment marks is so set that the system for the signal light 44 provides a convex-concave lens system while the system for the signal light 45 provides a concave-convex lens system. However, the system for the signal light 45 may comprise a convex-concave system. This is suitable when the invention is applied to such a system wherein the spacing δ between the first and second objects are relatively large.

Although the foregoing embodiments have been described with reference to cases wherein various signal processing methods for processing signals from the sensor, are applied to a positional deviation measuring system of the type wherein the position of the center of gravity of light, diffracted in sequence by physical optic elements each having a lens function and being displaceable on the sensor with a predetermined magnification, in accordance with the amount of positional deviation is detected, the applicability of the present invention is not limited to the positional deviation measuring system of the described type. The invention is applicable also to any other type of positional deviation measuring system, such as conventional measuring system shown in Figure 1, for example.

The interval detecting system shown in Figure 4B may be replaced by an optical system such as illustrated in Figure 16. In the interval detecting system shown in Figure 16, light emanating from a light source 31 and collimated by a lens 32 into a parallel light impinges on a physical optic element 42 on a mask, having a lens function. By this element, the light is diffracted and is transformed into a convergent light. The light emanating from the physical optic element (grating lens) 42 is reflected by the surface of a wafer and passes again the mask 1. At this time, the light does not go through a region of the mask in which the physical optic element 42 is formed, such that without being influenced by the diffracting function, it reaches a sensor 39. In this example, no detection lens such as at 36 is disposed in the path of the interval measuring light, and the light reflected by the wafer 2 surface and passing through the mask 1 directly impinges on the sensor 39. The position of incidence of the light on the sensor 39 is changeable with the mask-to-wafer interval and, by detecting the position of incidence, the interval therebetween is detected.

The detecting means is not limited to a solid image pickup element such as CCD, but any other means such as, for example, a photoelectric conversion type image pickup tube (e.g., vidicon, plumvicon or SIT tube), a position sensor (PSD) or otherwise may be used.

Next, a further embodiment of the present invention will be explained.

Initially, as a comparison example, the following case will be explained wherein the position resulting from averaging the positions of individual points in respect to light intensity (i.e. the position of the center of gravity of light) is taken as a representative.

The position of the center of gravity of light, i.e. vector $\vec{M}$, can be expressed by the following equation:

$$\vec{M} = (\sum_i Si \cdot \vec{ai}) / \sum_i Si \qquad \ldots (4)$$

Wherein i is natural number, Si is the light intensity at the i-th position, and $\vec{ai}$ is the position vector at the i-th position.

Where this method is applied to the detection of interval and positional deviation of the above-described light spot detection type wherein the light intensity signal is locally concentrated, the light intensity signal concentration occurs around the position of the gravity center and, as the distance from the position of the gravity center increases, the light intensity signal becomes weak. As compared therewith, if noise appears at every part of the sensor, at substantially the same probability and with substantially the same magnitude, in a limited range close to the position of the gravity center the noise produced thereat causes only a small amount of shift of the position $\vec{M}$ of the gravity center of light, because the magnitude of the original signal is large and thus the signal-to-noise ratio is sufficiently high and because the amount of contribution of the noise at the right-hand side of equation (1) is sufficiently small. However, the noise can be produced at every part of the sensor, substantially at uniform possibility. Therefore, the rate of production of noise is higher in a wide range of low level signal region, far away from the gravity center position, than in the limited range adjacent the gravity center position. Additionally, since the signal level in this region is low, any noise produced in that region makes the signal-to-noise ratio quite low. Therefore, a large change occurs in the right-hand side of equation (1), and the amount of change in the gravity center position $\vec{M}$ of the light due to such noise is large. Accordingly, where the gravity center position is taken as a representative position for the spot of focused light and if the positional deviation or interval is detected on the basis of any deviation from this representative position, the produced noise easily causes a detection error.

In the present embodiment, in consideration of the above, the light intensity signal concentrated locally is amplified at a rate higher than that for the signal in a wide range of low level signal region, and with regard to these signals the following processing is made to determine the representative position. As a consequence, the representative position does not easily change with the noise in the low level region.

The representative position (vector) $\vec{M}'$ in that case can be expressed as follows:

$$\overrightarrow{M'} = \sum_{i} Ai \cdot (Si)^{\alpha i} \cdot \overrightarrow{ai} / \sum_{i} Ai \cdot (Si)^{\alpha i} \qquad \ldots(5)$$

wherein $Ai$ amd $\alpha i$ are specific coefficients at the i-th position.

The coefficients $Ai$ and $\alpha i$ are set so as to amplify at a higher rate the signal $Si$ in the signal concentrated part, but so as not to amplify at a high rate the signal in the low level signal region or, alternatively, so as to reduce the same. To allow this, $Ai$ may be equal to 1 and $\alpha i$ may be equal to 2 (i.e. square amplification of the signal $Si$). Here, the calculation according to equation (5) is called the "detection of the gravity center position of squared light intensity". A particular example wherein the setting is such as described above will be explained below.

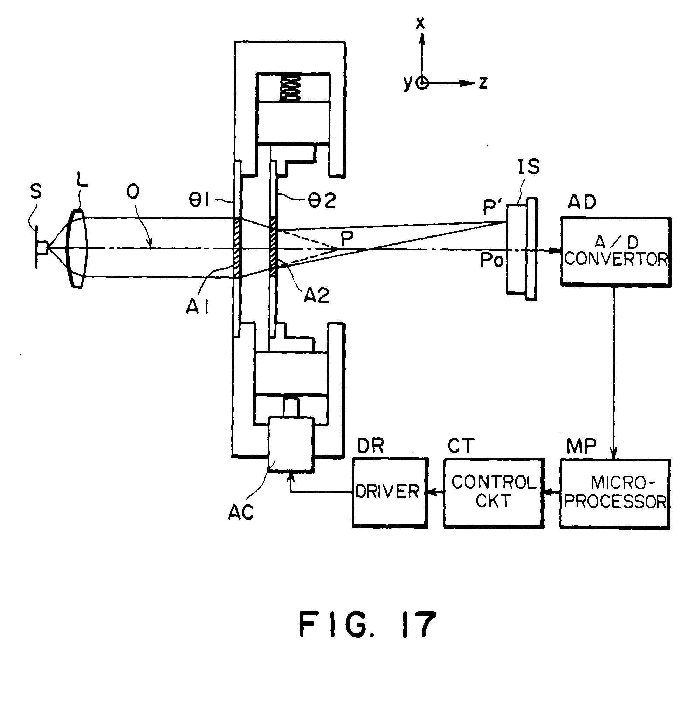

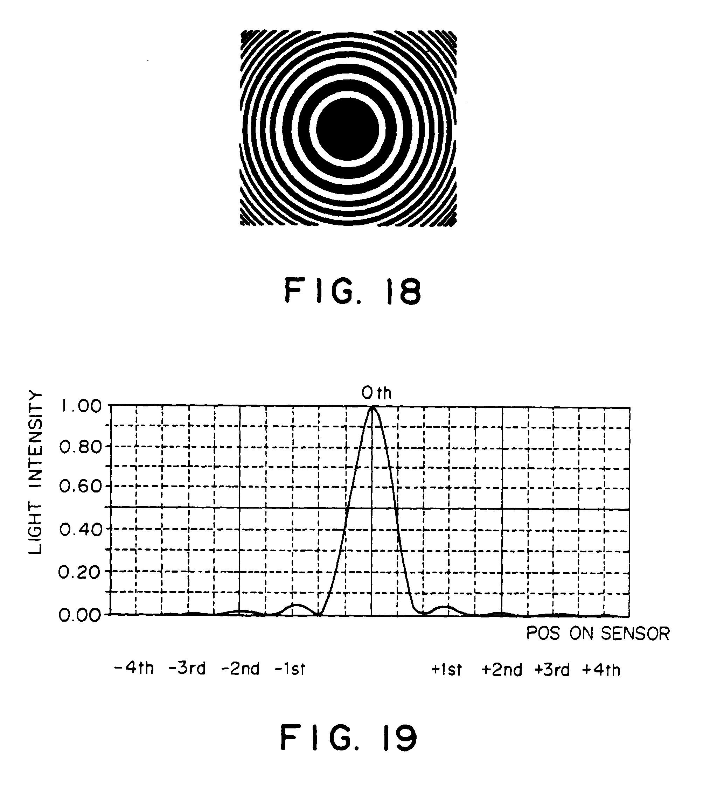

Figure 17 shows an embodiment wherein the invention is applied to an alignment system. Denoted at S is a laser source (light source) which produces light of good directivity. Denoted at L is a lens for collimating a laser beam from the source. The collimated laser beam impinges on a physical optic element A1 which is an alignment mark provided on an object Q1 (e.g., mask) to be aligned. The physical optic element A1 comprises a Fresnel zone plate, for example, having a lens function for concentrating the received light. Physical optic element A2 which is an alignment mark similar to the element A1, provided on an object Q2 (e.g., wafer) to be aligned, comprises a Fresnel zone plate, for example, having a lens function for concentrating, at a point on an image sensor IS, the incident light having been converged by the physical optic element A1 to be focused at a point P. When the objects Q1 and Q2 have no relative positional deviation, the physical optic elements A1 and A2 serve to focus the light at the center $P_0$ of the image sensor IS. If the object Q2 is deviated in a vertical direction as viewed in the drawing, these physical optic elements serve to focus the light at a point P' on the sensor IS, which is shifted in the same direction of the positional deviation and by an amount equal to the amount of positional deviation between the objects Q1 and Q2 as multiplied by . Accordingly, by detecting the amount and direction of the deviation of the point P' of focused light through the image sensor IP, the positional deviation between the objects Q1 and Q2 can be detected. By way of example, each of the physical optic elements A1 and A2 can be provided by a Fresnel zone plate such as shown in Figure 18. In this Figure, the painted areas depict the light-intercepting grating portions. Such Fresnel zone plate has the following configuration:

First, the mark A1 for the mask Q1 is designed so that when a parallel light of a predetermined beam diameter is incident thereupon at a predetermined angle, the light is collected at a predetermined position. Usually, the pattern of a Fresnel zone plate may be that of an interference fringe which can be formed on a lens surface in an occasion where mutually coherent light sources are disposed at a light source position (object point) and the position of an image point.

Assuming, a coordinate system is defined on the surface of the first object Q1, wherein the origin is at the middle of the Fresnel zone plate A1, the x axis lies in the positional deviation detecting direction (vertical direction in the drawing), the y axis lies in a direction which is on the surface of the object Q1 and which is perpendicular to the x axis, and the z axis lies in the direction of a normal to the surface of the object Q1. Equations regarding a group of curves lines of such a grating lens by which a parallel light, having been incident thereon with an angle $\alpha$ with respect to the normal to the object Q1 and with the projection being perpendicular to the x-axis direction, is imaged after being transmissibly diffracted by the mark of the object Q1, at the position of a converging point P $(x_1, y_1, z_1)$, can be expressed in the following manner, with the position of each grating being denoted by x, y:

$$y\sin\alpha + P_1\ (x,y) - P_2 = m\lambda/2 \qquad\qquad (6)$$

$$P_1(x) = \sqrt{(x\text{-}x_1)^2 + (y\text{-}y_1)^2 + z_1^2}$$

$$P_2 = \sqrt{x_1^2 + y_1^2 + z_1^2}$$

wherein $\lambda$ is the wavelength of the light and m is an integral number.

Assuming now that a chief ray is such a ray being incident with an angle $\alpha$ and passing through the origin on the surface of the object Q1 and then impinging upon the convergent point P $(x_1, y_1, z_1)$, then the right side of equation (6) shows that, depending on the value of m, the optical path length is "$\lambda$ x m/2" times longer (shorter) than that for the chief ray; and the left side denotes the difference in length, with respect to the optical path of the chief ray, of the optical path of such a ray that passes a point (x, y, 0) on the object Q1 and then impinges on the point $(x_1, y_1, z_1)$.

On the other hand, a Fresnel zone plate A2 to be provided on the object Q2 is designed so as to collect, at a predetermined position (on the sensor IS surface), a spherical wave emanating from a predetermined point light source.

Where the gap between the first and second objects Q1 and Q2 is denoted by g, then such a point light source is at the position of the imaging point defined by the Fresnel zone Q1, which can be expressed by:

$(x_1, y_1, z_1\text{-}g)$

Assuming now that the objects Q1 and Q2 are to be aligned with respect to the x-axis direction and that, upon completion of alignment, the light is focused at a point $P_0$ $(x_2, y_2, z_2)$ on the sensor IS surface, then equations regarding a group of curved lines of gratings of a Fresnel zone plate A2 to be provided on the object Q2, can be expressed, in the coordinate system defined hereinbefore, as follows:

$$\sqrt{(x\text{-}x_2)^2 + (y\text{-}y_2)^2 + z_2^2}$$
$$-\sqrt{(x\text{-}x_1)^2 + (y\text{-}y_1)^2 + (z_1\text{-}g)^2}$$
$$= \sqrt{x_2^2 + y_2^2 + z_2^2} - \sqrt{x_1^2 + y_1^2 + z_1^2} + m\lambda/2 \tag{7}$$

Equation (7) is such an equation that satisfied a condition under which, assuming that the object Q2 is at "z = -g" and that the chief ray is such a ray that passes the origin on the object Q1 surface and a point (0, 0-g) on the object Q2 surface and additionally a point $P_0$ $(x_2, y_2, z_2)$ on the sensor IS surface, the difference in length between the path of the chief ray and the path of a ray passing the grating (x, y, -g) on the object Q2 surface becomes equal to a multiple, by an integral number, of a half wavelength.

Referring back to Figure 17, the light focused on the image sensor IS is photoelectrically converted and then is transformed by an analog-to-digital converter AD into a digital signal. Then, through a microprocessor MP, the above-described representative point of the light focused on the sensor IS is detected. In other words, the light intensity detection signals of the picture elements of the image sensor IS are squared and, with regard to the thus obtained signals (i.e. with regard to the squared light intensities) the calculation according to equation (5) is made to determine a representative point.

Control system CT operates in response to the information from the microprocessor MP and instructs through a driver DR the operation amount of the actuator AC so as to move the object Q2 by a suitable amount.

The operation will be explained in detail.

If the optical axis of the physical optic element A2 on the object Q2, to be aligned, is deviated by an amount $\delta$ from the optical axis O defined by the physical optic element A1 (which is coincident with the optical axis of the lens L), while retaining a parallel relationship therebetween, the position of the convergent point P' on the image sensor IS is displaced from the position $P_0$ by $\beta \cdot \delta$. The light intensity detection signal regarding the spot on the image sensor has a form which is provided by an inherent spot shape profile of the convergent point P as combined with :

(1) High-order Fraunhofer diffraction image due to the aperture shape of the physical optic elements $A_1$ and A2;
(2) Scattered light and speckle light from the objects 1 and 2; and
(3) Electric noise.

With regard to variation component, variable with time, of the electric noise (3), it is possible to remove this by averaging, with time, the data obtained within a certain time and by using the resultant as the detection data. With regard to the stationary component of the electric noise, stationary with time, it is possible to remove the same by predetecting such component and by providing an offset to the output signals for collection of the same.

Further, on the sensor IS, there are produced high-order Fraunhofer diffraction images of the aperture of the physical optic element, about the zero-th order light spot, such as illustrated in Figure 19. The effect of this will now be explained. Since the size of the image sensor IS is finite, Fraunhofer diffraction images of orders higher than a predetermined order do not lie on the sensor IS. However, if the objects Q1 and Q2, to be aligned, are relatively deviated while retaining a parallel relationship, the spot on the sensor IS is shifted from its original position with a result that the higher-order diffraction image component comes to the sensor IS surface, or such high order component having lying on the sensor IS goes out of the sensor IS surface. Therefore, if the individual positions are averaged in regard to the light intensity throughout the sensor IS surface, it is possible that the detected reference position of the height contains an error.

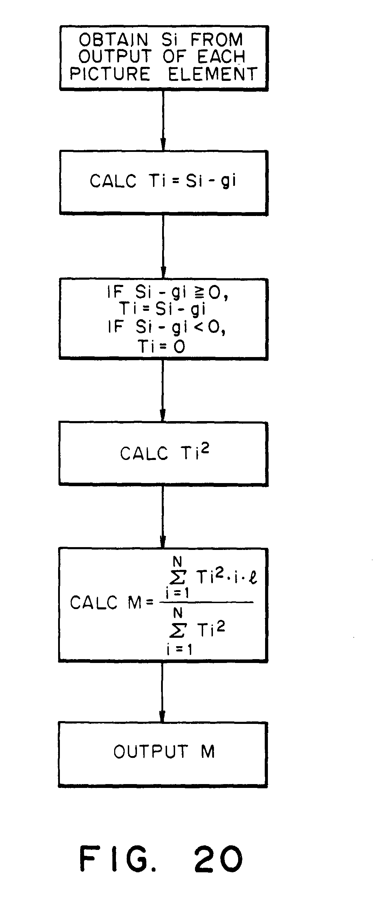

The process for removing an error, more particularly, an error due to the effect of such Fraunhofer diffraction image, is illustrated in the flow chart of Figure 20. It is to be noted here that the process of Figure 20 is that to be made for an image sensor IS which comprises a linear image sensor having its picture elements arrayed only in the positional deviation detecting direction (x direction). In the drawing, denoted at N is the total number of the picture elements, at i is the number of each picture element as counted from an end, at $\ell$ is the pitch of the picture elements of the sensor, at Si is the average light intensity at the i-th picture element, and at gi is the scattered light noise component at the i-th picture element. From the signals of the individual picture elements, an average Si of the light intensity in a certain time period is obtained and, by using Si, the reference position M is determined in accordance with the following equation:

$$M = (\sum_{i}^{N} Ti^2 \cdot i \cdot \ell)/\sum_{i}^{N} Ti^2 \qquad\qquad ...(8)$$

wherein

$$Ti = Si - gi \qquad if \qquad Si - gi \geqq 0$$

$$Ti = Q \qquad if \qquad Si - gi < 0$$

Here, gi can be determined by memorizing in a memory the sensor output data corresponding to the scattered light component when only the object Q1 is present and similar data when only the object Q2 is present and then by detecting the sum of the two data. The resultant provides the scattered light data. In this case, if gi is a constant value (an average value of the total scattered light noise components), as a whole it enhances the signal-to-noise ratio and, therefore, it has an effect of noise component removal. Also, for every picture element, gi is equal to zero, if only the Fraunhofer diffraction image is formed on the sensor.

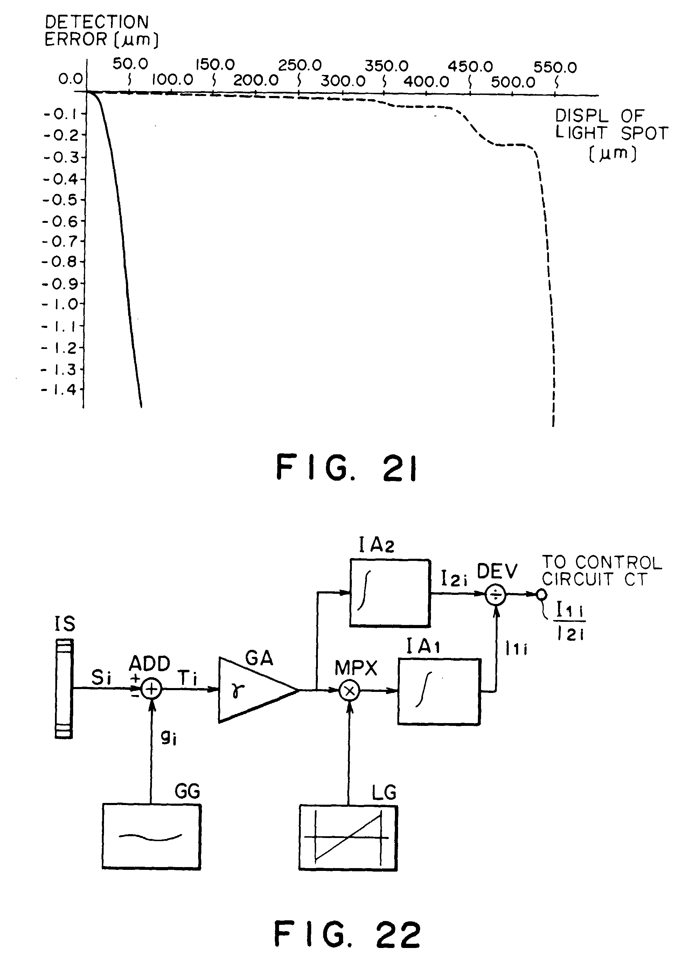

Figure 21 is a graph showing the results of simulation made of an assumption that the spot shape is the function of $sinC^2$ of 200 μm and that detection of a representative point is made by using a linear image sensor having a pitch of 30 μm x 40. In this graph, the positional deviation β·δ of the light spot on the sensor is depicted in the axis of abscissa, and the errors caused in the detection of the representative point in accordance with the squaring calculation of the present embodiment (broken line) and the errors causes by ordinary gravity center detection (solid line), both with respect to a reference displacement β·δ, are illustrated. It is seen in Figure 21 that the error in the detection of the spot displacement comes not more than 0.1 μm when deviation of the spot displacement is 20 μm in the case of the gravity center detecting method whereas it is 440 μm (about twenty times larger) in the case of detection according to the squaring calculation. From this, it is confirmed that the device of the present embodiment assures high-precision detection of the positional relationship, over a wide range.

If the image sensor IS comprises a two-dimensional image sensor, the square calculation may be made with Ai = 1, αi = 2 in equation (5). It will be understood that αi is not limited to "2", but it may be equal to n which is an arbitrary constant. Namely, substantially the same advantageous effects are obtainable by detecting the position of the gravity center of n-multiple value of the light intensity.

Figure 22 shows a further embodiment of the present invention. In this embodiment, the structure of the Figure 17 embodiment is modified in respect to the image sensor IS, the analog-to-digital converter AD and the microprocessor MP. The remaining part of the present embodiment is similar to that of the Figure 17 embodiment, and are not illustrated in Figure 22.

In Figure 22, denoted at GG is a gi-wave generator; at ADD is an adder; at GA is a gamma amplifier; at $IA_1$ and $IA_2$ are integrators; at MPX is a multiplier; at LG is a saw-tooth wave generator; and DEV is a divider.

As compared with the Figure 17 embodiment which executes digital signal processing, the present embodiment executes the analog signal processing.

In Figure 22, the light focused on the image sensor IS is photoelectrically converted, whereby a sensor output Si (analog signal) is produced. The output Si of the image sensor IS is not subjected to the analog-to-digital conversion but, by means of the other ADD, it is directly subjected to the subtraction with the analog signal gi of the scattered light noise component corresponding to the picture element number i of the image sensor as outputted from the gi wave generator GG, whereby it is transformed into an analog signal Ti (= Si - gi). Then, signal Ti is squared, for example, by the gamma amplifier GA, and is amplified by an output signal of the saw-tooth wave generator LG corresponding to the picture element number of the image sensor. Additionally, it is integrated by the integrator $IA_1$ ($I_{1i}$), integrating in a timed relationship with the scan of the image sensor IS. Simultaneously therewith, the output of the gamma amplifier is integrated ($I_{2i}$) by the integrator $IA_2$. The outputs of these integrators are applied to the divider DEV, whereby $I_{1i}/I_{2i}$ is calculated. The output of the divider DEV representing the average position as obtained by averaging the positions of the individual points in respect to the squared light intensity, is supplied to the control circuit CT.

While the operation is different in accordance with the difference between the digital processing and the analog processing, the major part thereof is the same as that of the Figure 17 embodiment. Therefore, description thereof will be omitted here.

It is to be noted that the applicability of the present invention is not limited to an alignment mechanism in a semiconductor device manufacturing apparatus. For example, the invention is applicable to the alignment in the hologram element setting, at the time of exposure reproduction of hologram, alignment in multi-color printing machine, the alignment in a bonding process of semiconductor chips, alignment process in an inspecting device for a print board and circuit, alignment at the adjustment of optical components or optical measuring system, interval measurement and so on.

**Claims**

1. A system for aligning a first and a second object (1,2) with each other comprising:

   light projecting means (31,32,33,34) for irradiating the first and second objects (1,2) with light;
   detecting means (38,39) for detecting the light intensity distribution in a predetermined detection plane, of light from the irradiated first and second objects (1,2) impinging on the detection plane, said detecting means (38,39) producing signals corresponding to the light intensities at different positions on the detection plane; said system being characterised in comprising:
   processing means (MP) for processing each signal from said detecting means (38,39) in accordance with a weight coefficient corresponding to the position or light intensity corresponding to that signal so as to determine the centre of gravity position of the light upon the detection plane;
   determining means for determining the relative positional relationship of the first and second objects (1,2) on the basis of the determined centre of gravity position; and
   alignment means for aligning the first and second objects (1,2) with each other.

2. A system according to Claim 1, wherein the first and second objects (1,2,) are disposed opposed to each other with a spacing therebetween, and wherein the relative positional relationship of the first and second objects (1,2) to be determined, is with respect to a direction perpendicular to a direction along the spacing between the first and second objects (1,2).

3. A system according to Claim 1, wherein the first and second objects (1,2) are disposed opposed to each other with a spacing therebetween, and wherein the relative positional relationship of the first and second objects (1,2) to be determined, is with respect to a direction along the spacing between the first and second objects (1,2).

4. A semiconductor device manufacturing apparatus comprising a system as recited in Claim 1, wherein the first object (1) is a mask (M) and the second object (2) is a wafer (W).

5. A method of aligning a first and second object (1,2) with each other comprising:

   irradiating the first and second objects (1,2) with light;
   detecting the light intensity distribution in a predetermined detection plane of light from the irradiated first and second objects (1,2) impinging on the detection plane so as to produce signals corresponding to the light intensities at different positions on the detection plane;
   said method being characterised in comprising the further steps of:
   processing each said signal in accordance with a weight coefficient corresponding to the position or light intensity corresponding to that signal so as to determine the centre of gravity position of the light upon the detection plane;
   determining the relative positional relationship of the first and second objects (1,2) on the basis of the determined centre of gravity position; and
   aligning the first and second objects (1,2) with each other.

6. A method of making a semiconductor microcircuit device including the step of aligning a mask with the semiconductor wafer using a method according to Claim 5 and including the further step of processing the semiconductor microcircuit device on the wafer.

**Patentansprüche**

1. System zum Ausrichten eines ersten Objekts **(1)** und eines zweiten Objekts **(2)** zueinander, welches aufweist:

   - eine Lichtprojektionseinrichtung **(31, 32, 33, 34)** zum Bestrahlen des ersten Objekts **(1)** und des zweiten Objekts **(2)** mit Licht,
   - eine Erfassungseinrichtung **(38, 39)** zum Erfassen der Lichtstärkeverteilung in einer vorbestimmten Erfassungsebene des Lichts von dem bestrahlten ersten Objekt **(1)** und dem bestrahlten zweiten Objekt **(2),** welches auf die Erfassungsebene auftrifft, die Erfassungseinrichtung **(38, 39)** Signale erzeugt, welche den Lichtstärken in unterschiedlichen Positionen auf der Erfassungsebene entsprechen, und das System

      **dadurch gekennzeichnet ist, daß** es aufweist:

   - eine Verarbeitungseinrichtung **(MP)** zum Verarbeiten jedes Signals von der Erfassungseinrichtung **(38, 39)** gemäß einem Schwerekoeffizient entsprechend der Position oder der Lichtstärke entsprechend diesem Signal, um so die Schwerpunktposition des Lichts auf der Erfassungsebene zu bestimmen,
   - eine Bestimmungseinrichtung zum Bestimmen der relativen Lagebeziehung des ersten Objekts **(1)** und des zweiter Objekts **(2)** auf der Grundlage der bestimmten Schwerpunktposition und
   - eine Ausrichteinrichtung zum Ausrichten des ersten Objekts **(1)** und des zweiten Objekts **(2)** zueinander.

2. System gemäß Anspruch 1, wobei das erste Objekt **(1)** und das zweite Objekt **(2)** einander in Gegenüberlage mit einem Zwischenraum angeordnet sind, und wobei die zu bestimmende relative Lagebeziehung des ersten Objekts **(1)** und des zweiten Objekts **(2)** mit Bezug auf eine Richtung senkrecht zu einer Richtung entlang dem Zwischenraum zwischen dem ersten Objekt **(1)** und dem zweiten Objekt **(2)** ist.

3. System gemäß Anspruch 1, wobei das erste Objekt **(1)** und das zweite Objekt **(2)** in Gegenüberlage zueinander mit einem Zwischenraum angeordnet sind, und wobei die zu bestimmende relative Lagebeziehung des ersten Objekts **(1)** und des zweiten Objekts **(2)** mit Bezug auf eine Richtung entlang dem Zwischenraum zwischen dem ersten Objekt **(1)** und dem zweiten Objekt **(2)** ist.

4. Halbleitereinrichtung-Fertigungsvorrichtung, welche ein System gemäß Anspruch 1 aufweist, wobei das erste Objekt **(1)** eine Maske **(M)** ist und das zweite Objekt **(2)** ein Wafer **(W)** ist.

5. Verfahren zum Ausrichten eines ersten Objekts **(1)** und eines zweiten Objekts **(2)** zueinander, welches aufweist:

   - Bestrahlen des ersten Objekts **(1)** und des zweiten Objekts **(2)** mit Licht,
   - Erfassen der Lichtstärkeverteilung in einer vorbestimmten Erfassungsebene des Lichts von dem bestrahlten ersten Objekt **(1)** und dem bestrahlten zweiten Objekt **(2)**, welches auf die Erfassungsebene auftrifft, um so Signale entsprechend den Lichtstärken in unterschiedlichen Positionen auf der Erfassungsebene zu bestimmen, und das Verfahren

      **dadurch gekennzeichnet ist, daß** es die weiteren Schritte aufweist:

   - Verarbeiten jedes Signals gemäß einem Schwerekoeffizient entsprechend der Position oder der Lichtstärke entsprechend diesem Signal, um so die Schwerpunktposition des Lichts auf der Erfassungsebene zu bestimmen,
   - Bestimmen der relativen Lagebeziehung des ersten Objekts **(1)** und des zweiten Objekts **(2)** auf der Grundlage der bestimmten Schwerpunktposition, und
   - Ausrichten des ersten Objekts **(1)** und des zweiten Objekts **(2)** zueinander.

6. Verfahren zur Herstellung einer Halbleiter-Mikroschaltkreis-Einrichtung, welches den Schritt des Ausrichtens einer Maske zum Halbleiterwafer unter Anwendung eines Verfahrens gemäß Anspruch 5 aufweist und den weiteren Schritt der Bearbeitung der Halbleiter-Mikroschaltkreis-Einrichtung auf dem Wafer aufweist.

**Revendications**

1. Système pour aligner entre eux des premier et second objets (1, 2), comportant :

des moyens (31, 32, 33, 34) de projection de lumière destinés à irradier de lumière les premier et second objets (1, 2),

des moyens (38, 39) de détection destinés à détecter la distribution, dans un plan prédéterminé de détection, de l'intensité de la lumière provenant des premier et second objets irradiés (1, 2) et tombant sur le plan de détection, lesdits moyens (38, 39) de détection produisant des signaux correspondant aux intensités lumineuses dans différentes positions sur le plan de détection ; ledit système étant caractérisé en ce qu'il comporte :

des moyens de traitement (MP) destinés à traiter chaque signal provenant desdits moyens de détection (38, 39) conformément à un coefficient de pondération correspondant à la position ou à l'intensité lumineuse correspondant à ce signal afin de déterminer le centre de la position de gravité de la lumière sur le plan de détection ;

des moyens de détermination destinés à déterminer les positions relatives des premier et second objets (1, 2) sur la base du centre de position de gravité déterminé ; et

des moyens d'alignement destinés à aligner entre eux les premier et second objets (1, 2).

2.  Système selon la revendication 1, dans lequel les premier et second objets (1, 2) sont disposés de façon à être opposés l'un à l'autre avec un écartement entre eux, et dans lequel les positions relatives des premier et second objets (1, 2) devant être déterminées sont situées par rapport à une direction perpendiculaire à une direction le long de l'écartement entre les premier et second objets (1, 2).

3.  Système selon la revendication 1, dans lequel les premier et second objets (1, 2) sont disposés de façon à être opposés l'un à l'autre avec un écartement entre eux et dans lequel les positions relatives des premier et second objets (1, 2) devant être déterminées sont situées par rapport à une direction le long de l'écartement entre les premier et second objets (1, 2).

4.  Appareil de fabrication de dispositifs semiconducteurs, comportant un système selon la revendication 1, dans lequel le premier objet (1) est un masque (M) et le second objet (2) et une tranche (W).

5.  Procédé d'alignement entre eux de premier et second objets (1, 2), comprenant :

    l'irradiation des premier et second objets (1, 2) avec de la lumière ;

    la détection de la distribution, dans un plan prédéterminé de détection, de l'intensité de la lumière provenant des premier et second objets irradiés (1, 2) et tombant sur le plan de détection afin de produire des signaux correspondants aux intensités lumineuses dans différentes positions sur le plan de détection ;

    ledit procédé étant caractérisé en ce qu'il comprend les autres étapes de :

    traitement de chacun desdits signaux conformément à un coefficient de pondération correspondant à la position ou à l'intensité lumineuse correspondant à ce signal afin de déterminer le centre de position de gravité de la lumière sur le plan de détection ;

    détermination des positions relatives des premier et second objets (1, 2) sur la base du centre de position de gravité prédéterminé ; et

    alignement entre eux des premier et second objets (1, 2).

6.  Procédé de réalisation d'un dispositif semiconducteur à microcircuit comprenant l'étape d'alignement d'un masque avec la tranche en semiconducteur en utilisant un procédé selon la revendication 5, et comprenant en outre l'étape de traitement du dispositif semiconducteur à microcircuit sur la tranche.

F I G. 1

F I G. 2

FIG. 3A

LASER DISTANCE
MEASURING DEVICE

22    21    23    24        21    22

2        25        1

# FIG. 3B

FIG. 3C

FIG. 3D

FIG. 3E

X

# FIG. 4A

# FIG. 4B

FIG. 5

FIG. 6A

FIG. 6B

29

FIG 7

FIG. 8A

FIG. 8B

A/D CONV OF
SENSOR OUTPUT

DATA TRANSFER
TO CPU

DETECT POS.
So ON SENSOR
CORRESPONDING TO
LIGHT QTY PEAK

MULTIPLY DATA OF
N PIXELS ABOUT So
BY WEIGHTING COEF
OF 1, & MULTIPLY
REMAINDER BY O

DETECT POS OF
CENTER OF G. OF
LIGHT QTY DISTR

# FIG. 9

**FIG. 10A**

SC

SCAN CKT

SEQUENTIAL READOUT

LIGHT INTERCEPTION

M

TEMPORAL STORAGE

OUTPUT

SIMULTANEOUS & PARALLEL TRANSFER

SENSOR MEANS

SR

SIMULTANEOUS CLEARANCE

EP 0 358 515 B1

FIG. 10B

FIG. IIA

FIG. IIB

PICTURE
ELEMENT 1024

PICTURE
ELEMENT 513

PICTURE
ELEMENT 512

PICTURE
ELEMENT 2

PICTURE
ELEMENT 1

37

SHIFT RANGE OF
GAP SIG LIGHT
(DEVIATION SIG LIGHT)

SHIFT RANGE OF
DEVIATION SIG LIGHT

FIG. 12

37

SHIFT RANGE
OF DEVIATION
SIG LIGHT

SHIFT RANGE OF
GAP SIG LIGHT
(DEVIATION SIG LIGHT)

Y

X

FIG. 13

FIG. 14A

FIG. 14B

FIG. 15

FIG. 16

# FIG. 17

F I G. 18

F I G. 19

OBTAIN Si FROM
OUTPUT OF EACH
PICTURE ELEMENT

CALC $Ti = Si - gi$

IF $Si - gi \geqq 0$,
$Ti = Si - gi$
IF $Si - gi < 0$,
$Ti = 0$

CALC $Ti^2$

$$\text{CALC } M = \frac{\sum\limits_{i=1}^{N} Ti^2 \cdot i \cdot \ell}{\sum\limits_{i=1}^{N} Ti^2}$$

OUTPUT M

# FIG. 20

EP 0 358 515 B1

FIG. 21

FIG. 22

42